# EUROPEAN PATENT APPLICATION

(11) **EP 4 711 780 A1**
(43) Date of publication of application: **18.03.2026**
(21) Application number: 25195147.1
(22) Date of filing: 11.08.2025
(51) Int. Cl.: G01R 31/317, G01R 31/3185

(54) **METHODS, APPARATUS, AND ARTICLES OF MANUFACTURE TO PERFORM INFIELD TESTING OF A SYSTEM IN A PACKAGE**

(30) Priority: 11.09.2024 US 202418882365
(71) Applicant: INTEL Corporation, Santa Clara, CA 95054 (US)
(72) Inventor: KANDULA, Rakesh, 560035 Bangalore (IN)
(74) Representative: HGF

(57) **Abstract**

Systems, apparatus, articles of manufacture, and methods are disclosed to perform infield testing of a system in a package. An example die includes transmit circuits to communicate via respective communication channels and control circuitry to cause a first one of the transmit circuits to send a first pattern over a first one of the communication channels. Additionally, the example control circuitry is to cause second ones of the transmit circuits to respectively send a second pattern over second respective ones of the communication channels, the second pattern being at least one of an inverse of the first pattern or identical to the first pattern.

## Description

### BACKGROUND

The electronics industry has moved towards more compact designs for integrated circuits. For example, electronics manufacturers have developed compact circuit designs such as a system on a chip (SoC) or a system in a package (SiP). SoCs and SiPs include most or all of the components of an electrical system but differ in how they are designed. For example, an SoC typically integrates components onto a single semiconductor die while an SiP typically includes multiple integrated circuits that are themselves integrated within a carrier package. An integrated circuit used in an SiP includes a semiconductor die and is sometimes referred to as a tile or a chiplet.

### BRIEF DESCRIPTION OF THE DRAWINGS

FIG. 1 is a block diagram of an example system in a package (SiP) including a first example transmitter and a first example receiver.
FIGS. 2A, 2B, 2C, 2D, 2E, and 2F are block diagrams illustrating example latent faults that can occur in an SiP.
FIG. 3A is a block diagram of an example implementation of the transmitter control circuitry of FIG. 1.
FIG. 3B is a block diagram of an example implementation of the receiver control circuitry of FIG. 1.
FIG. 4 illustrates an example implementation of a transmit circuit of the transmitter circuitry of FIG. 1.
FIG. 5 illustrates an example implementation of a receive circuit of the receiver circuitry of FIG. 1.
FIG. 6 is a graphical illustration depicting first example patterns communicated between the first transmitter and the third receiver of FIG. 1 during victim aggressor rotational testing (VART).
FIG. 7 is a graphical illustration depicting second example patterns communicated between the first transmitter and the third receiver of FIG. 1 during selective victim aggressor testing (SVAT).
FIG. 8 is a block diagram of an example system including example processor circuitry and the transmitter control circuitry and the receiver control circuitry of FIG. 1.
FIG. 9 is a block diagram of an example system including the example processor circuitry of FIG. 8 and one or more of the example transmitter circuitry or the example receiver circuitry of FIG. 1 to repair a defective communication channel.
FIG. 10A is a block diagram illustrating example communication between the transmitter circuitry and the receiver circuitry of FIG. 1 before a fault is detected.
FIG. 10B is a block diagram illustrating example communication between the transmitter circuitry and the receiver circuitry of FIG. 1 after the fault is repaired.
FIG. 11 is a block diagram of an example system to proactively repair example communication channels before a latent fault occurs.
FIG. 12 is a flowchart representative of example machine readable instructions and/or example operations that may be executed, instantiated, and/or performed by example programmable circuitry to implement the processor circuitry of FIG. 8.
FIG. 13 is a flowchart representative of example machine readable instructions and/or example operations that may be executed, instantiated, and/or performed by example programmable circuitry to implement the transmitter control circuitry of FIG. 3A.
FIG. 14 is a flowchart representative of example machine readable instructions and/or example operations that may be executed, instantiated, and/or performed by example programmable circuitry to implement the receiver control circuitry of FIG. 3B.
FIG. 15 is a flowchart representative of example machine readable instructions and/or example operations that may be executed, instantiated, and/or performed by example programmable circuitry to implement the system of FIG. 11.
FIG. 16 is a block diagram of an example processing platform including programmable circuitry structured to execute, instantiate, and/or perform the example machine readable instructions and/or perform the example operations of FIGS. 12, 13, 14, and/or 15 to implement the example transmitter control circuitry of FIG. 3A, the example receiver control circuitry of FIG. 3B, the example system of FIG. 8, the example system of FIG. 9, and/or the example system of FIG. 11.
FIG. 17 is a block diagram of an example implementation of the programmable circuitry of FIG. 16.
FIG. 18 is a block diagram of another example implementation of the programmable circuitry of FIG. 16.

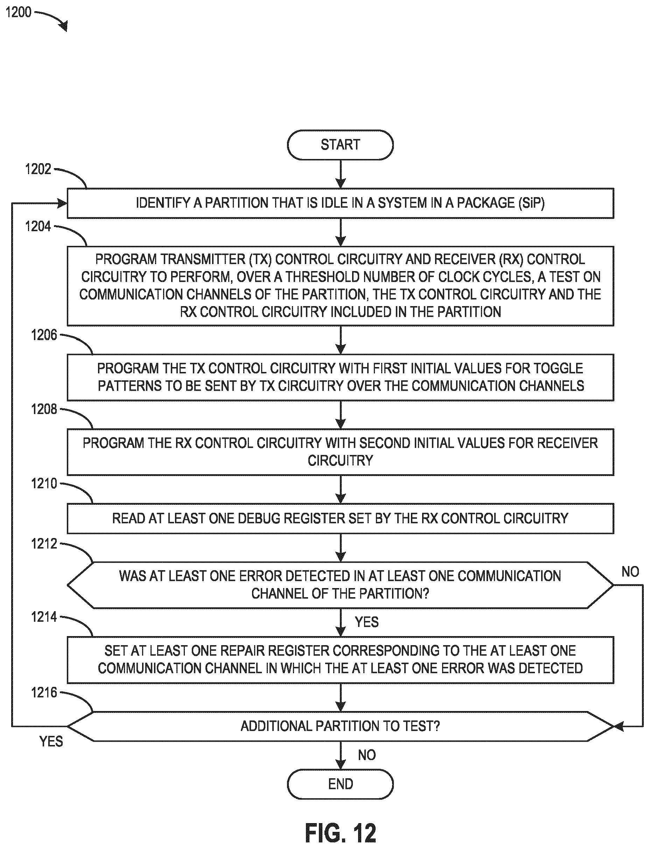

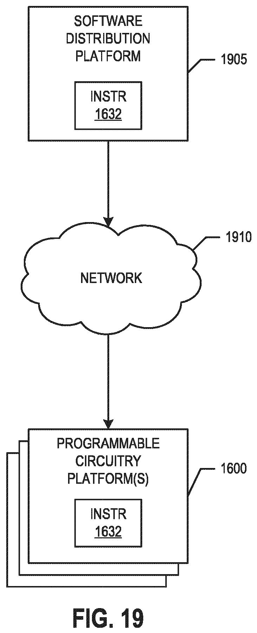

FIG. 19 is a block diagram of an example software/firmware/instructions distribution platform (e.g., one or more servers) to distribute software, instructions, and/or firmware (e.g., corresponding to the example machine readable instructions of FIGS. 12, 13, 14, and/or 15) to client devices associated with end users and/or consumers (e.g., for license, sale, and/or use), retailers (e.g., for sale, re-sale, license, and/or sub-license), and/or original equipment manufacturers (OEMs) (e.g., for inclusion in products to be distributed to, for example, retailers and/or to other end users such as direct buy customers).

In general, the same reference numbers will be used throughout the drawing(s) and accompanying written description to refer to the same or like parts. The figures are not necessarily to scale. Instead, the thickness of the layers or regions may be enlarged in the drawings. Although the figures show layers and regions with clean lines and boundaries, some or all of these lines and/or boundaries may be idealized. In reality, the boundaries and/or lines may be unobservable, blended, and/or irregular.

### DETAILED DESCRIPTION

SiPs typically include multiple integrated circuits (ICs) (e.g., tiles, chiplets) that are collectively integrated within a same carrier package. For example, the ICs are stacked using package on package mounting, placed side by side, and/or embedded in a substrate of the SiP. Package on package mounting includes coupling one or more leads of a first IC package to one or more leads of a second IC package to combine the first and second ICs vertically with respect to a substrate on which one of the first or second ICs is disposed. For example, the leads of the first and second ICs may be implemented by electrical pads that are interconnected via a ball grid array (BGA) or other surface mount technology (SMT).

To validate interconnects (e.g., communication channels) between ICs of an SiP, the interconnects are tested before the SiP is deployed (e.g., into the field, to a customer, etc.). Generally, testing of interconnects in an SiP involves testing for stuck-at defects and at-speed defects. A stuck-at defect refers to an interconnect that is hard stuck at logic 0 or logic 1. An at-speed defect refers to an interconnect that is slow to transition between states (e.g., slow to rise from logic 0 to logic 1 or slow to fall from logic 1 to logic 0).

As SiPs have become more integrated (e.g., for automotive, cloud computing, banking, etc. applications), the SMT used to couple the leads of ICs together has also decreased in size to allow for a greater number of interconnects between ICs and a smaller form factor for SiPs. For example, utilizing a BGA interconnect where individual balls have a diameter between 100 micrometers (µm) and 20-30 µm allows for communication channels between ICs to be spaced apart by 150-200 µm and 30-60 µm, respectively. Conversely, utilizing planar interconnects where individual interconnects have a width between 15-20 µm and 5 µm allows for communication channels to be spaced apart by 20-40 µm and 10 µm, respectively.

As the number of communication channels (e.g., crossings) between ICs increases and the space between communication channels (e.g., pitch) reduces, it is important to detect not only stuck-at fault, at-speed faults, and other static faults (e.g., bridging faults, shorts, opens, etc.), but also latent or transient faults that may occur on a communication channel before, after, and/or during deployment of an SiP. For example, latent faults or transient faults are faults that fall outside the categories of static faults such as stuck-at faults or at-speed faults, bridging faults, shorts, or opens. Latent faults are not static faults but can manifest in silicon based on the electrical stress of functional traffic communicated over a communication channel and the ageing of a part.

If a latent fault occurs on a communication channel, the latent fault can lead to system failure despite not being a static fault. For example, in automotive applications, if a latent fault manifests in part related to a braking system, the latent fault can lead to potential loss of life or destruction of a vehicle. Additionally or alternatively, if a latent fault manifests in a banking application, the latent fault can lead to failure in the security of privileged assets or data.

Advantageously, examples disclosed herein include infield detection of latent faults and predictive prevention of system failures due to manifestation of latent faults. For example, disclosed systems, methods, apparatus, and articles of manufacture repair communication channels even before a latent fault occurs and prevent system failure. Additionally, examples disclosed herein detect latent faults both before an SiP is deployed (e.g., at a manufacturing facility) and in the field. As such, examples disclosed herein prevent impacts of system failure such as loss of life or damage to privileged assets.

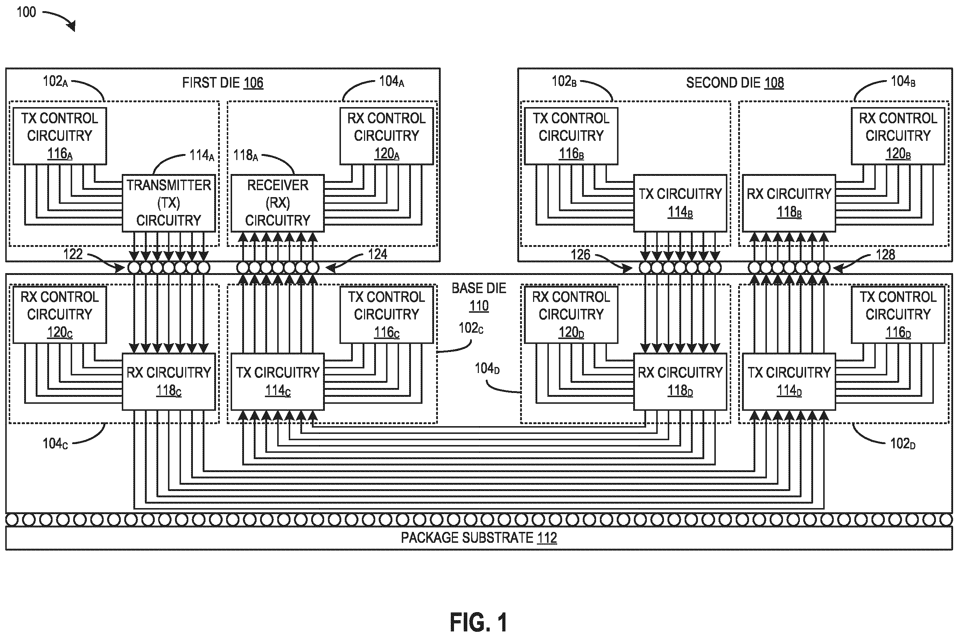

FIG. 1 is a block diagram of an example system in a package (SiP) 100 including a first example transmitter 102_{A} and a first example receiver 104_{A}. In the example of FIG. 1, the SiP 100 includes a first example die 106, a second example die 108, an example base die 110, and an example package substrate 112. In the example of FIG. 1, the first die 106 includes the first transmitter 102_{A} and the first receiver 104_{A}. Also, the second die 108 includes a second example transmitter 102_{B} and a second example receiver 104_{B}. In the example of FIG. 1, the base die 110 includes a third example transmitter 102_{C}, a third example receiver 104_{C}, a fourth example transmitter 102_{D} and a fourth example receiver 104_{D}.

In the illustrated example of FIG. 1, each of the first die 106, the second die 108, and the base die 110 is implemented by a semiconductor die that may be integrated in a package. For example each of the first die 106, the second die 108, and the base die 110 is a chiplet of the SiP 100. Additionally, the first die 106, the second die 108, the base die 110, and the package substrate 112 are integrated in a package (e.g., a semiconductor package). In some examples, the SiP 100 is implemented as an SoC. In such example, one or more of the first die 106, the second die 108, or the base die 110 may not be integrated in a package within the SoC. In the example of FIG. 1, each of the first die 106, the second die 108, and the base die 110 includes additional circuitry. For example, the additional circuitry can implement a network interface controller, an accelerator, a memory controller, a sensor, and/or a processor.

In the illustrated example of FIG. 1, the package substrate 112 is a base layer of the SiP 100 on which the base die 110 and/or additional base dies are disposed. For example, the first die 106, the second die 108, and the base die 110 can implement a logical component such as a central processor unit (CPU) and one or more additional base dies can host one or more dies to implement another logic component such as a network interface controller, an accelerator, a memory controller, and/or a sensor. In the example of FIG. 1, one or more logical components of the SiP 100 can communicate via communication channels embedded in the package substrate 112. Also, in the example of FIG. 1, the package substrate 112 is integrated within a package to form the SiP 100.

In the illustrated example of FIG. 1, each of the first transmitter 102_{A}, the second transmitter 102_{B}, the third transmitter 102_{C}, and the fourth transmitter 102_{D} includes an instance of example transmitter circuitry 114 and an instance of example transmitter control circuitry 116. For example, the first transmitter 102_{A} includes first example transmitter circuitry 114_{A} and first example transmitter control circuitry 116_{A}. Also, for example, the second transmitter 102_{B} includes second example transmitter circuitry 114_{B} and second example transmitter control circuitry 116_{B}. Additionally, the third transmitter 102_{C} includes third example transmitter circuitry 114_{C} and third example transmitter control circuitry 116_{C}. In the example of FIG. 1, the fourth transmitter 102_{D} includes fourth example transmitter circuitry 114_{D} and fourth example transmitter control circuitry 116_{D}.

In the illustrated example of FIG. 1, each of the first receiver 104_{A}, the second receiver 104_{B}, the third receiver 104_{C}, and the fourth receiver 104_{D} includes an instance of example receiver circuitry 118 and an instance of example receiver control circuitry 120. For example, the first receiver 104_{A} includes first example receiver circuitry 118_{A} and first example receiver control circuitry 120_{A}. Also, for example, the second receiver 104_{B} includes second example receiver circuitry 118_{B} and second example receiver control circuitry 120_{B}. Additionally, the third receiver 104_{C} includes third example receiver circuitry 118_{C} and third example receiver control circuitry 120_{C}. In the example of FIG. 1, the fourth receiver 104_{D} includes fourth example receiver circuitry 118_{D} and fourth example receiver control circuitry 120_{D}.

In the illustrated example of FIG. 1, the SiP 100 is divided into one or more partitions. For example, a partition refers to a logical grouping of components of an SiP that communicate over communication channels. For example, a first partition of the SiP 100 includes the first transmitter 102_{A}, the third receiver 104_{C}, and first example communication channels 122. Additionally, a second partition of the SiP 100 includes the third transmitter 102_{C}, the first receiver 104_{A}, and second example communication channels 124. A third partition of the SiP 100 includes the second transmitter 102_{B}, the fourth receiver 104_{D}, and third example communication channels 126. Also, a fourth partition of the SiP 100 includes the fourth transmitter 102_{D}, the second receiver 104_{B}, and fourth example communication channels 128.

As described further herein, each instance of the transmitter circuitry 114 includes a transmit circuit to facilitate communication over a corresponding communication channel. Additionally, as described further herein, each instance of the receiver circuitry 118 includes a receive circuit to facilitate communication over the corresponding communication channel. For example, if the first communication channels 122 include seven communication channels, then the first transmitter circuitry 114_{A} includes seven transmit circuits and the third receiver circuitry 118_{C} includes seven receive circuits. In such an example, the seven transmit circuits and the seven receive circuits are coupled to respective communication channels of the first communication channels 122.

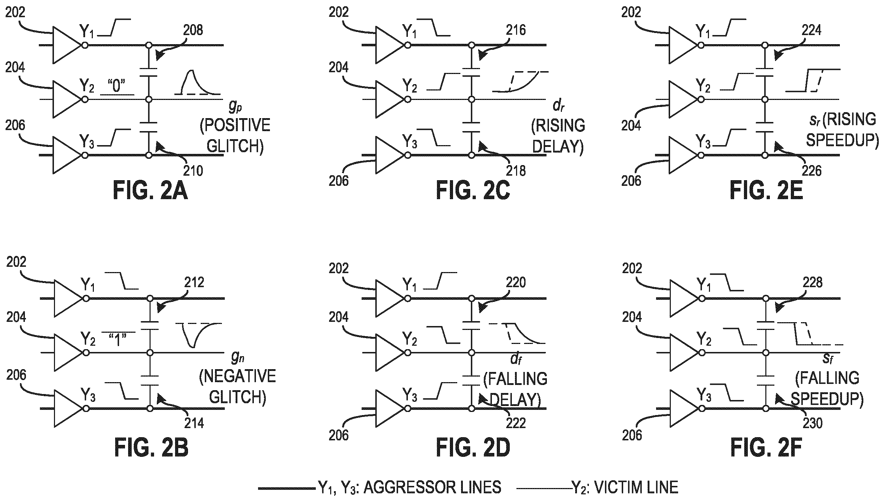

As described above, latent faults are faults that can manifest depending upon the stress of functional traffic on a communication channel. FIGS. 2A, 2B, 2C, 2D, 2E, and 2F are block diagrams illustrating example latent faults that can occur in an SiP. For example, latent faults result from crosstalk (e.g., electromagnetic interference) between communication channels. FIG. 2A is a block diagram including a first example NOT gate 202 beginning a first example communication channel Y₁, a second example NOT gate 204 beginning a second example communication channel Y₂, and a third example NOT gate 206 beginning a third example communication channel Y₃.

In the illustrated example of FIG. 2A, the first NOT gate 202 and the third NOT gate 206 are transmitting signals that are transitioning from a value of 0 to a value 1 while the second NOT gate 204 is transmitting a signal that has a value of 0. If at least one of a first example parasitic capacitance 208 between the first communication channel Y₁ and the second communication channel Y₂ or a second example parasitic capacitance 210 between the second communication channel Y₂ and the third communication channel Y₃ is large enough, the signal transmitted over the second communication channel Y₂ can be pulled up to a value of 1 for some period. As such, the second communication channel Y₂ is a victim line and the first communication channel Y₁ and the third communication channel Y₃ are aggressor lines. The latent fault illustrated in FIG. 2A is referred to as a positive glitch. Positive glitches can cause incorrect values to be communicated within an SiP which can lead to functional failures in the SiP.

In the illustrated example of FIG. 2B, the first NOT gate 202 and the third NOT gate 206 are transmitting signals that are transitioning from a value of 1 to a value 0 while the second NOT gate 204 is transmitting a signal that has a value of 1. If at least one of a third example parasitic capacitance 212 between the first communication channel Y₁ and the second communication channel Y₂ or a fourth example parasitic capacitance 214 between the second communication channel Y₂ and the third communication channel Y₃ is large enough, the signal transmitted over the second communication channel Y₂ can be pulled down to a value of 0 for some period. As such, the second communication channel Y₂ is a victim line and the first communication channel Y₁ and the third communication channel Y₃ are aggressor lines. The latent fault illustrated in FIG. 2B is referred to as a negative glitch. Negative glitches can cause incorrect values to be communicated within an SiP which can lead to functional failures in the SiP.

In the illustrated example of FIG. 2C, the first NOT gate 202 and the third NOT gate 206 are transmitting signals that are transitioning from a value of 1 to a value 0 while the second NOT gate 204 is transmitting a signal that is transitioning from a value of 0 to a value of 1. If at least one of a fifth example parasitic capacitance 216 between the first communication channel Y₁ and the second communication channel Y₂ or a sixth example parasitic capacitance 218 between the second communication channel Y₂ and the third communication channel Y₃ is large enough, the signal transmitted over the second communication channel Y₂ can be delayed in transitioning between values. As such, the second communication channel Y₂ is a victim line and the first communication channel Y₁ and the third communication channel Y₃ are aggressor lines. The latent fault illustrated in FIG. 2C is referred to as a rising delay. Rising delays can cause timing violations in an SiP which can lead to functional failures in the SiP.

In the illustrated example of FIG. 2D, the first NOT gate 202 and the third NOT gate 206 are transmitting signals that are transitioning from a value of 0 to a value 1 while the second NOT gate 204 is transmitting a signal that is transitioning from a value of 1 to a value of 0. If at least one of a seventh example parasitic capacitance 220 between the first communication channel Y₁ and the second communication channel Y₂ or an eighth example parasitic capacitance 222 between the second communication channel Y₂ and the third communication channel Y₃ is large enough, the signal transmitted over the second communication channel Y₂ can be delayed in transitioning between values. As such, the second communication channel Y₂ is a victim line and the first communication channel Y₁ and the third communication channel Y₃ are aggressor lines. The latent fault illustrated in FIG. 2D is referred to as a falling delay. Falling delays can cause timing violations in an SiP which can lead to functional failures in the SiP.

In the illustrated example of FIG. 2E, the first NOT gate 202 and the third NOT gate 206 are transmitting signals that are transitioning from a value of 0 to a value 1 while the second NOT gate 204 is transmitting a signal that is transitioning from a value of 0 to a value of 1. If at least one of a ninth example parasitic capacitance 224 between the first communication channel Y₁ and the second communication channel Y₂ or a tenth example parasitic capacitance 226 between the second communication channel Y₂ and the third communication channel Y₃ is large enough, the signal transmitted over the second communication channel Y₂ can be sped up in transitioning between values. As such, the second communication channel Y₂ is a victim line and the first communication channel Y₁ and the third communication channel Y₃ are aggressor lines. The latent fault illustrated in FIG. 2E is referred to as a rising speedup. Rising speedups can cause hold violations (e.g., a signal transitioning from a static value earlier than intended) in an SiP which can lead to functional failures in the SiP.

In the illustrated example of FIG. 2F, the first NOT gate 202 and the third NOT gate 206 are transmitting signals that are transitioning from a value of 1 to a value 0 while the second NOT gate 204 is transmitting a signal that is transitioning from a value of 1 to a value of 0. If at least one of an eleventh example parasitic capacitance 228 between the first communication channel Y₁ and the second communication channel Y₂ or a twelfth example parasitic capacitance 230 between the second communication channel Y₂ and the third communication channel Y₃ is large enough, the signal transmitted over the second communication channel Y₂ can be sped up in transitioning between values. As such, the second communication channel Y₂ is a victim line and the first communication channel Y₁ and the third communication channel Y₃ are aggressor lines. The latent fault illustrated in FIG. 2F is referred to as a falling speedup. Falling speedups can cause hold violations (e.g., a signal transitioning from a static value earlier than intended) in an SiP which can lead to functional failures in the SiP.

Returning to the example of FIG. 1, the type of functional traffic that will occur in the SiP 100 after deployment cannot be predicted. As such, a specific type of latent fault cannot be tested for before deployment of the SiP 100. Advantageously, the transmitter control circuitry 116 and the receiver control circuitry 120 can test (e.g., perform a built in, self-test (BIST)) for the most electrically stressful traffic which can detect any type of latent fault illustrated in FIGS. 2A, 2B, 2C, 2D, 2E, and 2F. For example, because the six types of latent faults are known ahead of time, the transmitter control circuitry 116 can inject a test pattern on communication channels to test one of the six latent faults. Each type of latent fault can be tested for each communication channel as the victim.

As such, for *N* communication channels, the transmitter control circuitry 116 and the receiver control circuitry 120 can run 6*N* iterations of a test. For example, in the first six iterations of the test, the transmitter control circuitry 116 causes a first transmit circuit corresponding to a victim lane to send a first pattern at a first time and the other transmit circuits corresponding to aggressor lanes to send a second pattern (e.g., the opposite pattern, an inverse pattern of the first pattern, etc.) at a first time. Additionally, for example, in the next six iterations of the test, the transmitter control circuitry 116 causes a third transmit circuit corresponding to the next victim lane to send the first pattern at a second time (e.g., different than the first time) and the other transmit circuits corresponding to an aggressor lane to send the second pattern at the third time. As such, the transmitter control circuitry 116 can continue iterating through the test with different communication channels acting as the victim lane until the 6N iterations are complete.

In the illustrated example of FIG. 1, each instance of the transmitter control circuitry 116 and each instance of the receiver control circuitry 120 is capable of performing a test on corresponding communication channels of an associated partition of the SiP 100. That is, the first transmitter control circuitry 116_{A} and the third receiver control circuitry 120_{C} are capable of performing a test on the first communication channels 122. For example, if the first communication channels 122 include N communication channels, then the first transmitter control circuitry 116_{A} and the third receiver control circuitry 120_{C} perform a test including 6N iterations to determine if any of the six latent faults illustrated in FIGS. 2A, 2B, 2C, 2D, 2E, and 2F are present in any of the N communication channels as described above.

As such, the 6N iterations performed by the first transmitter control circuitry 116_{A} and the third receiver control circuitry 120_{C} cover all process variations and physical defects that can cause crosstalk effects on any of the N communication channels. In addition to covering the six latent faults illustrated in FIGS. 2A, 2B, 2C, 2D, 2E, and 2F, the 6N iterations performed by the first transmitter control circuitry 116_{A} and the third receiver control circuitry 120_{C} also allow for detection of static faults such as stuck-at faults, stuck-open faults, and bridging faults. In some examples, one pattern can be used to detect multiple latent faults illustrated in FIGS. 2A-2F.

For example, positive glitches and rising delays can be tested for using one toggle pattern (e.g., the pattern illustrated in FIG. 2C) by running the test at a lower frequency. As such, there is a longer period between transitions which allows for parasitic capacitance to develop between the victim lane and the aggressor lanes. Additionally or alternatively, negative glitches and falling delays can be tested for using one toggle pattern (e.g., the pattern illustrated in FIG. 2D) by running the test at a lower frequency. As such, there is a longer period between transitions which allows for parasitic capacitance to develop between the victim lane and the aggressor lanes. In this manner, one test pattern can be used to for multiple types of latent faults.

As described above, a latent fault can manifest at any time, even after the SiP 100 is deployed. Advantageously, control circuitry (e.g., a microcontroller, a power management unit (PMU) or a power management controller (PMC) programmed by firmware, etc.) of the SiP 100 can trigger the transmitter control circuitry 116 and the receiver control circuitry 120 to perform the above-described test before deployment as well as after the SiP 100 is in the field. For example, before deployment, the control circuitry (e.g., a microcontroller, a PMU or a PMC programmed by firmware, etc.) can test the first transmitter 102_{A} and the first receiver 104_{A} before the first die 106 is coupled to the base die 110. As such, the control circuitry (e.g., a microcontroller, a PMU or a PMC programmed by firmware, etc.) can detect if there are any faults (e.g., static or latent) in the first transmitter circuitry 114_{A} and/or the first receiver circuitry 118_{A} before coupling the first die 106 to the base die 110.

Additionally, after the first die 106 is coupled to the base die 110, the control circuitry (e.g., a microcontroller, a PMU or a PMC programmed by firmware, etc.) can test the first transmitter 102_{A} and the third receiver 104_{C}. As such, the control circuitry (e.g., a microcontroller, a PMU or a PMC programmed by firmware, etc.) can detect if there are any faults (e.g., static or latent) in the first communication channels 122 before deployment of the SiP 100. In the example of FIG. 1, when the SiP 100 is deployed in the field, the control circuitry (e.g., a microcontroller, a PMU or a PMC programmed by firmware, etc.) monitors one or more partitions to detect a trigger event.

For example, a trigger event is a partition that is idle for at least a threshold period of time. Additionally or alternatively, a trigger event is a key-on event (e.g., when a vehicle is turned on) or a key-off event (e.g., when a vehicle is turned off). For example, after a key-on event or a key-off event, there is a period during which power is supplied to the SiP 100, but the SiP 100 is not being utilized by a vehicle. As such, one or more tests can be run in this period. In the example of FIG. 1, based on detecting a trigger event for a partition, the control circuitry (e.g., a microcontroller, a PMU or a PMC programmed by firmware, etc.) programs an instance of the transmitter control circuitry 116 and an instance of the receiver control circuitry 120 to perform the test on communication channels of the partition over a threshold number of clock cycles.

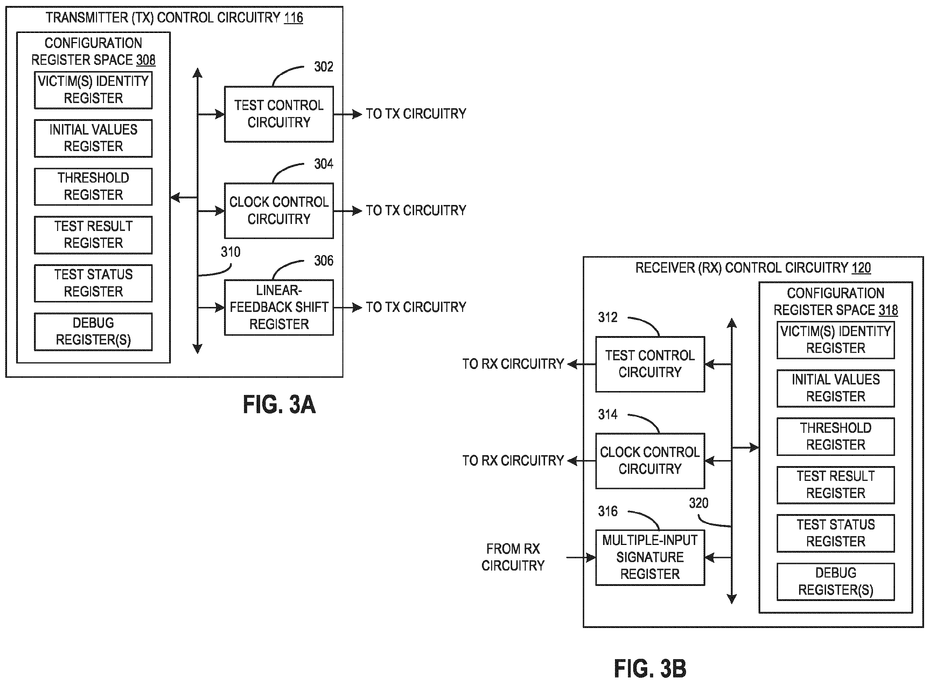

FIG. 3A is a block diagram of an example implementation of the transmitter control circuitry 116 of FIG. 1. In the example of FIG. 3A, the transmitter control circuitry 116 includes example test control circuitry 302, example clock control circuitry 304, an example linear-feedback shift register (LFSR) 306, and example configuration register space 308. In the example of FIG. 3A, the test control circuitry 302, the clock control circuitry 304, the LFSR 306, and the configuration register space 308 are in communication via an example communication bus 310. For example, the communication bus 310 may be implemented using any suitable wired and/or wireless communication. In additional or alternative examples, the communication bus 310 can be implemented via software, machine readable instructions, and/or communication protocols by which information is communicated among the test control circuitry 302, the clock control circuitry 304, the LFSR 306, and/or the configuration register space 308.

In the illustrated example of FIG. 3A, the transmitter control circuitry 116 may be instantiated (e.g., creating an instance of, bring into being for any length of time, materialize, implement, etc.) by programmable circuitry such as a CPU executing first instructions. Additionally or alternatively, the transmitter control circuitry 116 of FIG. 3A may be instantiated (e.g., creating an instance of, bring into being for any length of time, materialize, implement, etc.) by (i) an Application Specific Integrated Circuit (ASIC) and/or (ii) a Field Programmable Gate Array (FPGA) structured and/or configured in response to execution of second instructions to perform operations corresponding to the first instructions. It should be understood that some or all of the circuitry of FIG. 3A may, thus, be instantiated at the same or different times. Some or all of the circuitry of FIG. 3A may be instantiated, for example, in one or more threads executing concurrently on hardware and/or in series on hardware. Moreover, in some examples, some or all of the circuitry of FIG. 3A may be implemented by microprocessor circuitry executing instructions and/or FPGA circuitry performing operations to implement one or more virtual machines and/or containers.

In the illustrated example of FIG. 3A, the configuration register space 308 includes one or more example victim identity registers, an example initial values register, an example threshold register, an example test result register, an example test status register, and one or more example debug registers. As such, the control circuitry (e.g., a microcontroller, a PMU or a PMC programmed by firmware, etc.) can program the transmitter control circuitry 116 to perform the test on communication channels. For example, the control circuitry can identify one or more communication channels that are to be a victim line with respect other communication channels of the partition and a threshold number of clock cycles over which the transmitter control circuitry 116 is to perform the test.

As described above, a victim line is a communication channel on which a signal is transmitted while other communication channels (e.g., aggressor lines) transmit a different signal. In this manner, the victim line can be subjected to EMI to determine if a latent or other fault is present. In the example of FIG. 3A the test control circuitry 302 selects a first communication channel to test (e.g., as identified by the one or more victim identity registers of the configuration register space 308). As described above, each communication channel is associated with a corresponding transmit circuit and a corresponding receive circuit. As described further herein, each transmit circuit and each receive circuit includes a first clock having a first frequency and a second clock having a second frequency faster (e.g., greater) than the first frequency.

In the illustrated example of FIG. 3A, the test control circuitry 302 initializes a first transmit circuit corresponding to the selected communication channel to a first value. Additionally, the test control circuitry 302 initializes second transmit circuits to a second value different than the first value. For example, the test control circuitry 302 initializes the first transmit circuit and the second transmit circuits based on the initial values register of the configuration register space 308. In the example of FIG. 3A, the test control circuitry 302 initializes the first transmit circuit and the second transmit circuits while the first transmit circuit and the second transmit circuits are operating at the first frequency.

In the illustrated example of FIG. 3A, the clock control circuitry 304 disables the respective first clocks and the respective second clocks of the first transmit circuit and the second transmit circuits. Additionally, the clock control circuitry 304 causes the first transmit circuit and the second transmit circuits to operate at the second frequency of the respective second clocks. In the example of FIG. 3A, the clock control circuitry 304 enables the respective second clocks of the first transmit circuit and the second transmit circuits.

In the illustrated example of FIG. 3A, the LFSR 306 is implemented by one or more registers. In additional or alternative examples, the LFSR 306 can be implemented by pattern generation circuitry. In the example of FIG. 3A, the LFSR 306 generates test data to cause (1) the first transmit circuit to send a first pattern to a first receive circuit over the selected communication channel and (2) the second transmit circuits to send a second pattern to second receive circuits over second communication channels. For example, the first pattern is the opposite of the second pattern as described above with respect to victim and aggressor lines. In the example of FIG. 3A, after the threshold number of clock cycles, the clock control circuitry 304 disables the respective first clocks and the respective second clocks of the first transmit circuit and the second transmit circuits. Additionally, the clock control circuitry 304 causes the first transmit circuit and the second transmit circuits to operate at the first frequency of the respective first clocks.

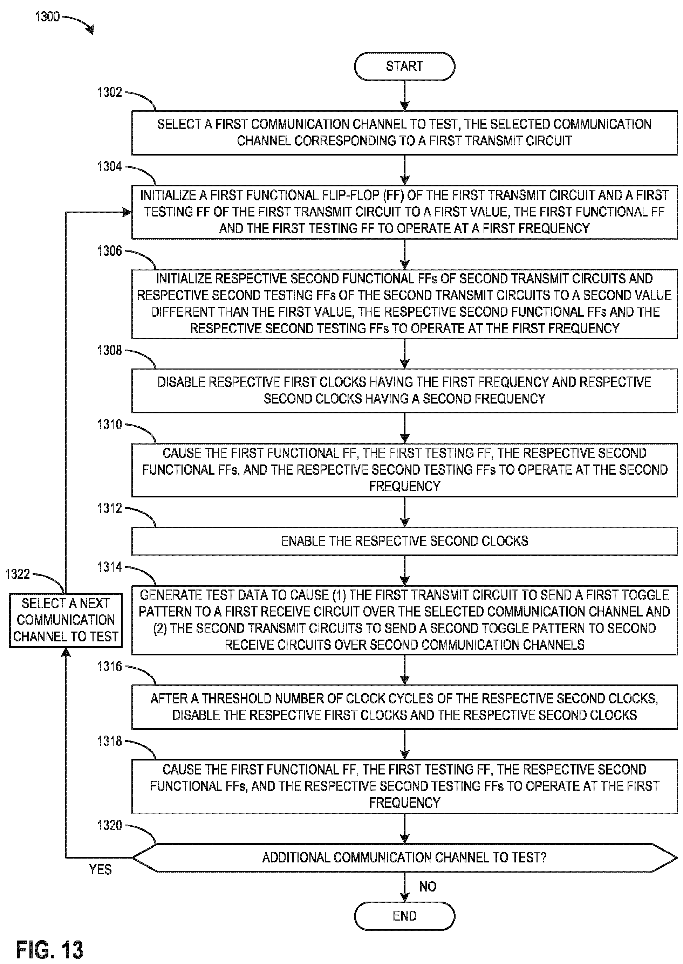

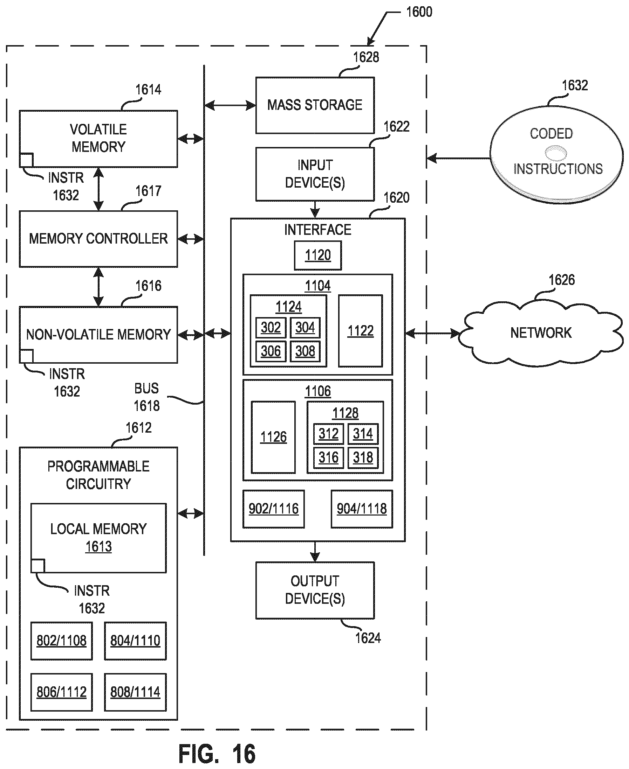

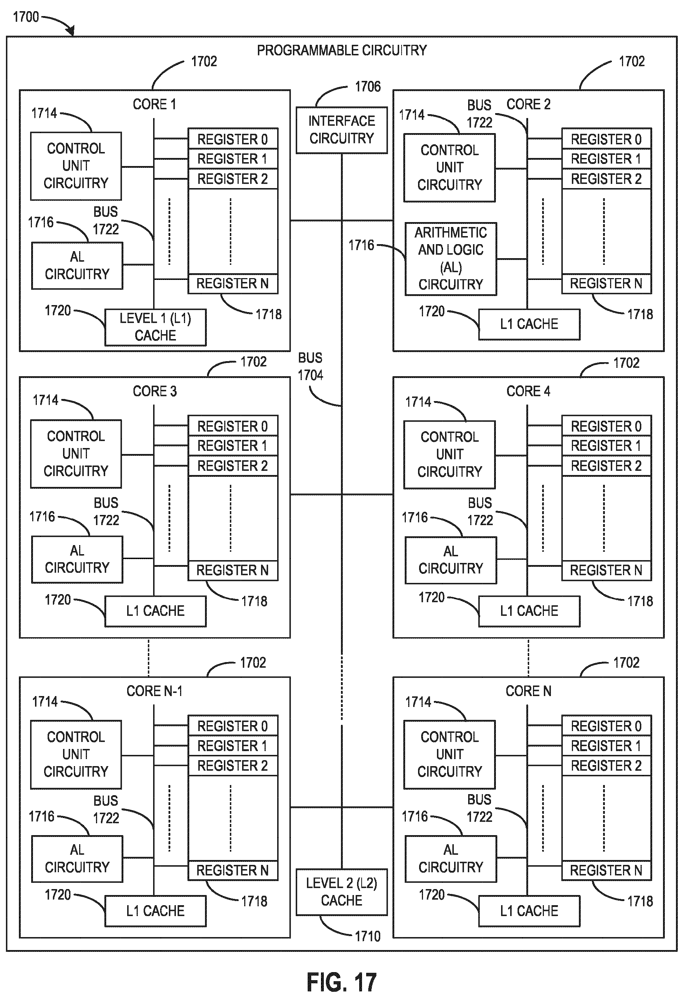

In some examples, the test control circuitry 302 is instantiated by programmable circuitry executing test control instructions and/or configured to perform operations such as those represented by the flowchart(s) of FIG. 13. In some examples, the transmitter control circuitry 116 includes means for controlling a test. For example, the means for controlling may be implemented by the test control circuitry 302. In some examples, the test control circuitry 302 may be instantiated by programmable circuitry such as the example programmable circuitry 1612 of FIG. 16. For instance, the test control circuitry 302 may be instantiated by the example microprocessor 1700 of FIG. 17 executing machine executable instructions such as those implemented by at least blocks 1302, 1304, 1306, 1320, and 1322 of FIG. 13.

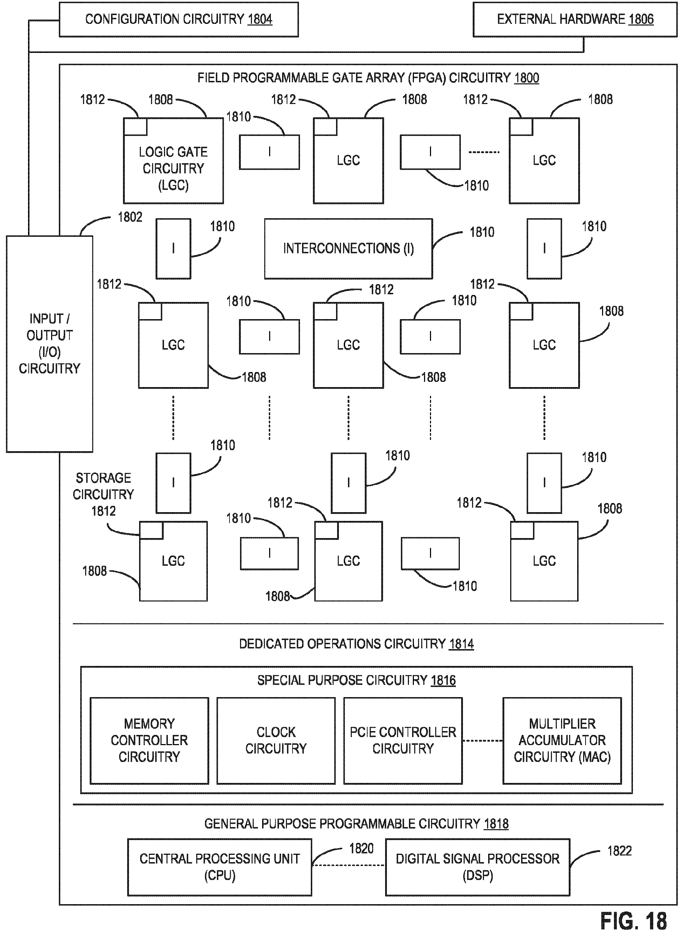

In some examples, the test control circuitry 302 may be instantiated by hardware logic circuitry, which may be implemented by an ASIC, XPU, or the FPGA circuitry 1800 of FIG. 18 configured and/or structured to perform operations corresponding to the machine-readable instructions. Additionally or alternatively, the test control circuitry 302 may be instantiated by any other combination of hardware, software, and/or firmware. For example, the test control circuitry 302 may be implemented by at least one or more hardware circuits (e.g., processor circuitry, discrete and/or integrated analog and/or digital circuitry, an FPGA, an ASIC, an XPU, a comparator, an operational-amplifier (op-amp), a logic circuit, etc.) configured and/or structured to execute some or all of the machine readable instructions and/or to perform some or all of the operations corresponding to the machine readable instructions without executing software or firmware, but other structures are likewise appropriate.

In some examples, the clock control circuitry 304 is instantiated by programmable circuitry executing clock control instructions and/or configured to perform operations such as those represented by the flowchart(s) of FIG. 13. In some examples, the transmitter control circuitry 116 includes means for controlling at least one clock. For example, the means for controlling may be implemented by the clock control circuitry 304. In some examples, the clock control circuitry 304 may be instantiated by programmable circuitry such as the example programmable circuitry 1612 of FIG. 16. For instance, the clock control circuitry 304 may be instantiated by the example microprocessor 1700 of FIG. 17 executing machine executable instructions such as those implemented by at least blocks 1308, 1310, 1312, 1316, and 1318 of FIG. 13.

In some examples, the clock control circuitry 304 may be instantiated by hardware logic circuitry, which may be implemented by an ASIC, XPU, or the FPGA circuitry 1800 of FIG. 18 configured and/or structured to perform operations corresponding to the machine-readable instructions. Additionally or alternatively, the clock control circuitry 304 may be instantiated by any other combination of hardware, software, and/or firmware. For example, the clock control circuitry 304 may be implemented by at least one or more hardware circuits (e.g., processor circuitry, discrete and/or integrated analog and/or digital circuitry, an FPGA, an ASIC, an XPU, a comparator, an operational-amplifier (op-amp), a logic circuit, etc.) configured and/or structured to execute some or all of the machine readable instructions and/or to perform some or all of the operations corresponding to the machine readable instructions without executing software or firmware, but other structures are likewise appropriate.

In some examples, the LFSR 306 is instantiated by programmable circuitry executing test data generating instructions and/or configured to perform operations such as those represented by the flowchart(s) of FIG. 13. In some examples, the transmitter control circuitry 116 includes means for generating test data. For example, the means for generating may be implemented by the LFSR 306. In some examples, the LFSR 306 may be instantiated by programmable circuitry such as the example programmable circuitry 1612 of FIG. 16. For instance, the LFSR 306 may be instantiated by the example microprocessor 1700 of FIG. 17 executing machine executable instructions such as those implemented by at least block 1312 of FIG. 13.

In some examples, the LFSR 306 may be instantiated by hardware logic circuitry, which may be implemented by an ASIC, XPU, or the FPGA circuitry 1800 of FIG. 18 configured and/or structured to perform operations corresponding to the machine-readable instructions. Additionally or alternatively, the LFSR 306 may be instantiated by any other combination of hardware, software, and/or firmware. For example, the LFSR 306 may be implemented by at least one or more hardware circuits (e.g., processor circuitry, discrete and/or integrated analog and/or digital circuitry, an FPGA, an ASIC, an XPU, a comparator, an operational-amplifier (op-amp), a logic circuit, etc.) configured and/or structured to execute some or all of the machine readable instructions and/or to perform some or all of the operations corresponding to the machine readable instructions without executing software or firmware, but other structures are likewise appropriate.

FIG. 3B is a block diagram of an example implementation of the receiver control circuitry 120 of FIG. 1. In the example of FIG. 3B, the receiver control circuitry 120 includes example test control circuitry 312, example clock control circuitry 314, an example multiple-input signature register (MISR) 316, and example configuration register space 318. In the example of FIG. 3B, the test control circuitry 312, the clock control circuitry 314, the MISR 316, and the configuration register space 318 are in communication via an example communication bus 320. For example, the communication bus 320 may be implemented using any suitable wired and/or wireless communication. In additional or alternative examples, the communication bus 320 can be implemented via software, machine readable instructions, and/or communication protocols by which information is communicated among the test control circuitry 312, the clock control circuitry 314, the MISR 316, and/or the configuration register space 318.

In the illustrated example of FIG. 3B, the receiver control circuitry 120 may be instantiated (e.g., creating an instance of, bring into being for any length of time, materialize, implement, etc.) by programmable circuitry such as a CPU executing first instructions. Additionally or alternatively, the receiver control circuitry 120 of FIG. 3B may be instantiated (e.g., creating an instance of, bring into being for any length of time, materialize, implement, etc.) by (i) an Application Specific Integrated Circuit (ASIC) and/or (ii) a Field Programmable Gate Array (FPGA) structured and/or configured in response to execution of second instructions to perform operations corresponding to the first instructions. It should be understood that some or all of the circuitry of FIG. 3B may, thus, be instantiated at the same or different times. Some or all of the circuitry of FIG. 3B may be instantiated, for example, in one or more threads executing concurrently on hardware and/or in series on hardware. Moreover, in some examples, some or all of the circuitry of FIG. 3B may be implemented by microprocessor circuitry executing instructions and/or FPGA circuitry performing operations to implement one or more virtual machines and/or containers.

In the illustrated example of FIG. 3B, the configuration register space 318 includes one or more example victim identity registers, an example initial values register, an example threshold register, an example test result register, an example test status register, and one or more example debug registers. As such, the control circuitry (e.g., a microcontroller, a PMU or a PMC programmed by firmware, etc.) can program the receiver control circuitry 120 to perform the test on communication channels. For example, the control circuitry can identify one or more communication channels that are to be a victim line with respect other communication channels of the partition and a threshold number of clock cycles over which the receiver control circuitry 120 is to perform the test.

In the illustrated example of FIG. 3B the test control circuitry 312 selects a first communication channel to monitor (e.g., as identified by the one or more victim identity registers of the configuration register space 308). As described above, each communication channel is associated with a corresponding transmit circuit and a corresponding receive circuit. As described further herein, each transmit circuit and each receive circuit includes a first clock having a first frequency and a second clock having a second frequency faster (e.g., greater) than the first frequency.

In the illustrated example of FIG. 3B, the test control circuitry 312 initializes a first receive circuit corresponding to the selected communication channel to a first value. Additionally, the test control circuitry 312 initializes second receive circuits to a second value different than the first value. For example, the test control circuitry 312 initializes the first receive circuit and the second receive circuits based on the initial values register of the configuration register space 318. In the example of FIG. 3B, the test control circuitry 312 initializes the first receive circuit and the second receive circuits while the first receive circuit and the second receive circuits are operating at the first frequency.

In the illustrated example of FIG. 3B, the clock control circuitry 314 disables the respective first clocks and the respective second clocks of the first receive circuit and the second receive circuits. Additionally, the clock control circuitry 314 causes the first receive circuit and the second receive circuits to operate at the second frequency of the respective second clocks. In the example of FIG. 3B, the clock control circuitry 314 enables the respective second clocks of the first receive circuit and the second receive circuits.

In the illustrated example of FIG. 3B, the MISR 316 collects test data from the first receive circuit and the second receive circuits. For example, by enabling the respective second clocks of the first receive circuit and the second receive circuits, the clock control circuitry 314 causes (1) the first receive circuit to receive a first pattern from a first transmit circuit over the selected communication channel and (2) the second receive circuits to receive a second pattern from second transmit circuits over second communication channels. By collecting data from the first receive circuits and the second receive circuits, the MISR 316 is able to collect data for the test.

In the illustrated example of FIG. 3B, the first pattern is the opposite of the second pattern as described above with respect to victim and aggressor lines. In the example of FIG. 3B, after the threshold number of clock cycles, the clock control circuitry 314 disables the respective first clocks and the respective second clocks of the first receive circuit and the second receive circuits. Additionally, the clock control circuitry 314 causes the first transmit circuit and the second transmit circuits to operate at the first frequency of the respective first clocks. In the example of FIG. 3B, the test control circuitry 312 reads an output register of the receiver circuitry 118 to determine if an error is present in any of thew first communication channel or the second communication channels. Additionally, the test control circuitry 312 sets at least one debug register in the configuration register space 318 based on whether at least one error was detected (e.g., based on patterns received at the receiver circuitry 118).

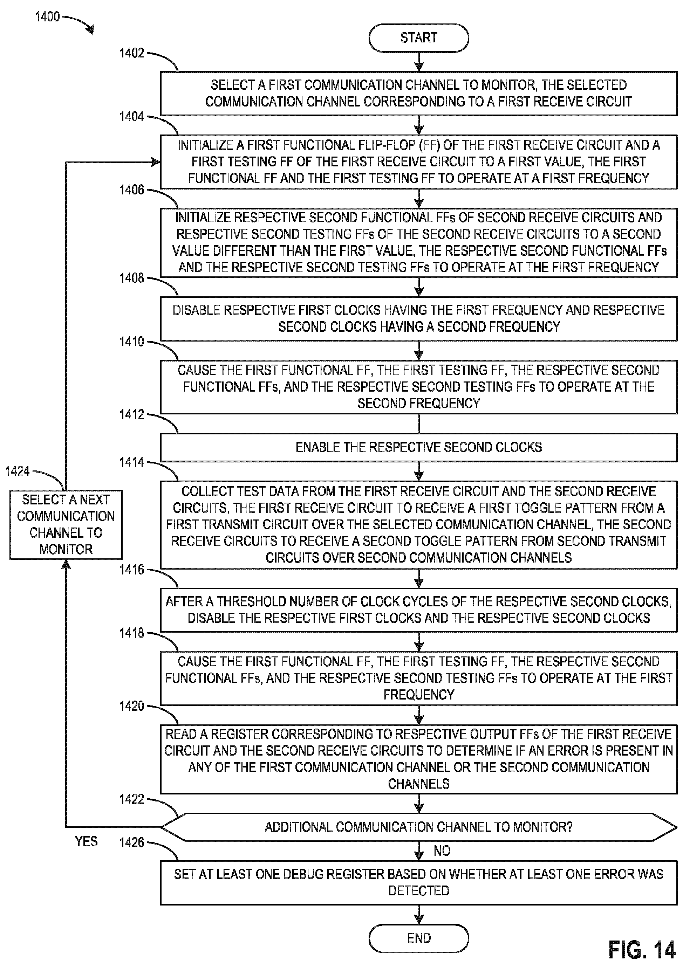

In some examples, the test control circuitry 312 is instantiated by programmable circuitry executing test control instructions and/or configured to perform operations such as those represented by the flowchart(s) of FIG. 14. In some examples, the receiver control circuitry 120 includes means for controlling a test. For example, the means for controlling may be implemented by the test control circuitry 312. In some examples, the test control circuitry 312 may be instantiated by programmable circuitry such as the example programmable circuitry 1612 of FIG. 16. For instance, the test control circuitry 312 may be instantiated by the example microprocessor 1700 of FIG. 17 executing machine executable instructions such as those implemented by at least blocks 1402, 1404, 1406, 1420, 1422, 1424, and 1426 of FIG. 13.

In some examples, the test control circuitry 312 may be instantiated by hardware logic circuitry, which may be implemented by an ASIC, XPU, or the FPGA circuitry 1800 of FIG. 18 configured and/or structured to perform operations corresponding to the machine-readable instructions. Additionally or alternatively, the test control circuitry 312 may be instantiated by any other combination of hardware, software, and/or firmware. For example, the test control circuitry 312 may be implemented by at least one or more hardware circuits (e.g., processor circuitry, discrete and/or integrated analog and/or digital circuitry, an FPGA, an ASIC, an XPU, a comparator, an operational-amplifier (op-amp), a logic circuit, etc.) configured and/or structured to execute some or all of the machine readable instructions and/or to perform some or all of the operations corresponding to the machine readable instructions without executing software or firmware, but other structures are likewise appropriate.

In some examples, the clock control circuitry 314 is instantiated by programmable circuitry executing clock control instructions and/or configured to perform operations such as those represented by the flowchart(s) of FIG. 14. In some examples, the receiver control circuitry 120 includes means for controlling at least one clock. For example, the means for controlling may be implemented by the clock control circuitry 314. In some examples, the clock control circuitry 314 may be instantiated by programmable circuitry such as the example programmable circuitry 1612 of FIG. 16. For instance, the clock control circuitry 314 may be instantiated by the example microprocessor 1700 of FIG. 17 executing machine executable instructions such as those implemented by at least blocks 1408, 1410, 1412, 1416, and 1418 of FIG. 14.

In some examples, the clock control circuitry 314 may be instantiated by hardware logic circuitry, which may be implemented by an ASIC, XPU, or the FPGA circuitry 1800 of FIG. 18 configured and/or structured to perform operations corresponding to the machine-readable instructions. Additionally or alternatively, the clock control circuitry 314 may be instantiated by any other combination of hardware, software, and/or firmware. For example, the clock control circuitry 314 may be implemented by at least one or more hardware circuits (e.g., processor circuitry, discrete and/or integrated analog and/or digital circuitry, an FPGA, an ASIC, an XPU, a comparator, an operational-amplifier (op-amp), a logic circuit, etc.) configured and/or structured to execute some or all of the machine readable instructions and/or to perform some or all of the operations corresponding to the machine readable instructions without executing software or firmware, but other structures are likewise appropriate.

In some examples, the MISR 316 is instantiated by programmable circuitry executing test data collecting instructions and/or configured to perform operations such as those represented by the flowchart(s) of FIG. 14. In some examples, the receiver control circuitry 120 includes means for collecting test data. For example, the means for collecting may be implemented by the MISR 316. In some examples, the MISR 316 may be instantiated by programmable circuitry such as the example programmable circuitry 1612 of FIG. 16. For instance, the MISR 316 may be instantiated by the example microprocessor 1700 of FIG. 17 executing machine executable instructions such as those implemented by at least block 1414 of FIG. 14.

In some examples, the MISR 316 may be instantiated by hardware logic circuitry, which may be implemented by an ASIC, XPU, or the FPGA circuitry 1800 of FIG. 18 configured and/or structured to perform operations corresponding to the machine-readable instructions. Additionally or alternatively, the MISR 316 may be instantiated by any other combination of hardware, software, and/or firmware. For example, the MISR 316 may be implemented by at least one or more hardware circuits (e.g., processor circuitry, discrete and/or integrated analog and/or digital circuitry, an FPGA, an ASIC, an XPU, a comparator, an operational-amplifier (op-amp), a logic circuit, etc.) configured and/or structured to execute some or all of the machine readable instructions and/or to perform some or all of the operations corresponding to the machine readable instructions without executing software or firmware, but other structures are likewise appropriate.

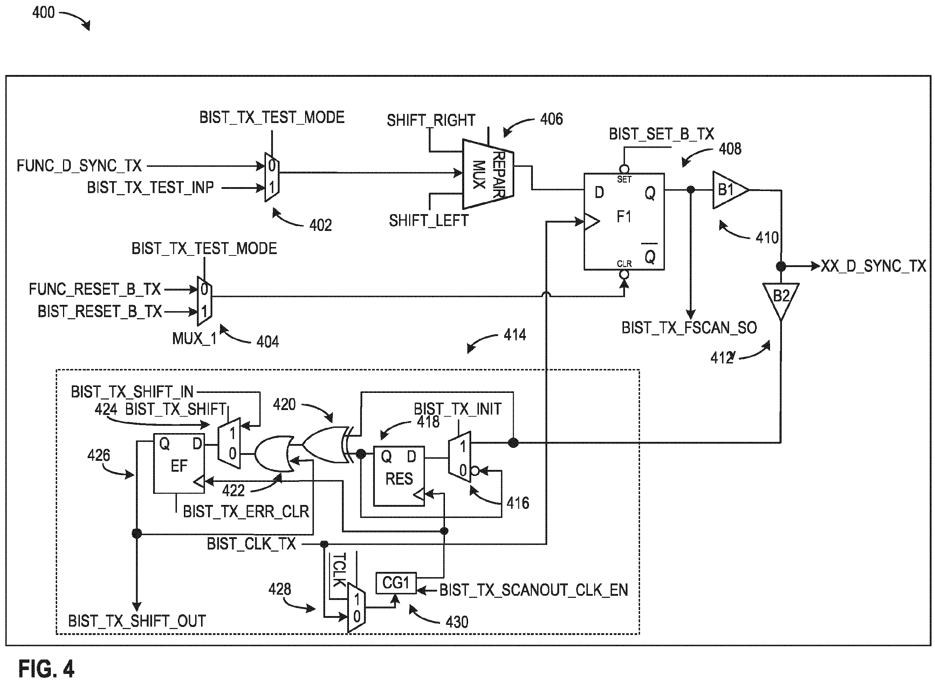

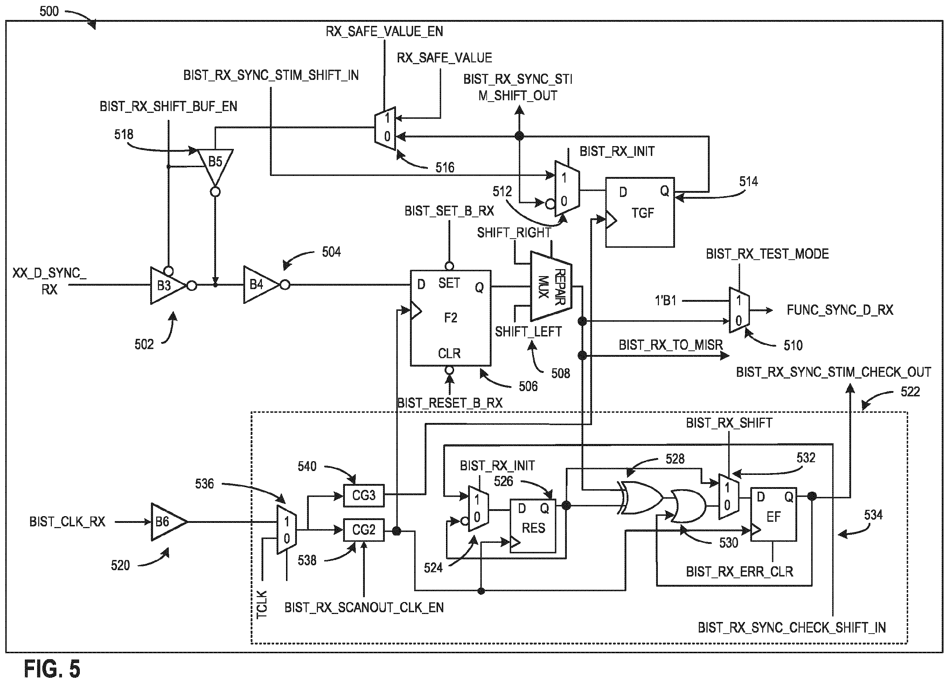

FIGS. 4 and 5 illustrate an example transmit circuit 400 of the transmitter circuitry 114 of FIG. 1 and an example receive circuit 500 of the receiver circuitry 118 of FIG. 1 that are in communication via a communication channel. For example, the transmit circuit 400 of FIG. 4 includes a first example multiplexer 402, a second example multiplexer 404, a first example repair multiplexer 406, a first functional flip-flop 408, a first example buffer 410, a second example buffer 412, and a first example testing circuit 414. The first example testing circuit 414 of FIG. 4 includes a third example multiplexer 416, a first example testing flip-flop 418, a first example exclusive OR (XOR) gate 420, a first example OR gate 422, a fourth example multiplexer 424, and a first example output flip-flop 426.

Additionally, the first testing circuit 414 of FIG. 4 includes a fifth example multiplexer 428 and first example clock gating circuitry 430. In the examples of FIGS. 4 and 5, the transmit circuit 400 also includes a first clock having a first frequency (e.g., TCLK) and a second clock having a second frequency (e.g., BIST_CLK_TX) (e.g., greater than the first frequency). For example, the transmit circuit 400 utilizes the first clock during initialization of a test and during read out of the test data. In some examples, the transmit circuit 400 utilizes the second clock during performance of the test.

In the illustrated examples of FIGS. 4 and 5, the example receive circuit 500 of FIG. 5 includes a third example buffer 502, a fourth example buffer 504, a second example functional flip-flop 506, a second example repair multiplexer 508, a sixth example multiplexer 510, a seventh example multiplexer 512, an example initialization flip-flip 514, an eighth example multiplexer 516, a fifth example buffer 518, a sixth example buffer 520, and a second example testing circuit 522. The second example testing circuit 522 of FIG. 5 includes a ninth example multiplexer 524, a second example testing flip -flop 526, a second example exclusive OR (XOR) gate 528, a second example OR gate 530, a tenth example multiplexer 532, and a second example output flip-flop 534.

Additionally, the second testing circuit 522 of FIG. 5 includes an eleventh example multiplexer 536, second example clock gating circuitry 538, and third example clock gating circuitry 540. In the examples of FIGS. 4 and 5, the receive circuit 500 also includes a first clock having a first frequency (e.g., TCLK) and a second clock having a second frequency (e.g., BIST_CLK_RX) (e.g., greater than the first frequency). For example, the receive circuit 500 utilizes the first clock during initialization of a test and during read out of the test data. In some examples, the receive circuit 500 utilizes the second clock during performance of the test.

As described above, the SiP 100 includes a transmit circuit and a corresponding receive circuit for each communication channel. Additionally, as described above, the SiP 100 includes a large number of communication channels. For example, the SiP 100 includes anywhere from 1,000s of communication channels to hundreds of 1,000s of communication channels. Also, as described above, the transmit circuit 400 and the receive circuit 500 can be tested before respective dies including the transmit circuit 400 and the receive circuit 500 are coupled to the SiP 100. Additionally, as described above, a communication channel between the transmit circuit 400 and the receive circuit 500 can be tested after respective dies including the transmit circuit 400 and the receive circuit 500 are coupled to the SiP 100.

In the illustrated examples of FIGS. 4 and 5, the first functional flip-flop 408 and the second functional flip-flop 506 are part of functional logic circuitry to be tested in respective dies. During nominal operation, the input to the first functional flip-flop 408 is multiplexed between a test pattern (e.g., a BIST_TX_TESTsignal) and a functional signal (e.g., a FUNC_D_SYNC_TX signal) produced by combinational logic circuitry. Additionally, for example, combinational logic circuitry at the output of the second functional flip-flop 506 is multiplexed (e.g., via the sixth multiplexer 510) between a static value (e.g., to be used during testing) and the signal output from the second functional flip-flop 506 (e.g., to be used during functional operation). Additionally, the MISR 316 receives signal output from the second functional flip-flop 506.

As described above, the input to the first functional flip-flop 408 is multiplexed between a test pattern and a functional signal during nominal operation. For example, during nominal operation, the first repair multiplexer 406 operates as a passthrough component (e.g., does not switch between the output of the first multiplexer 402 and either of the shift_right or shift_left inputs). Additionally, during nominal operation, the second repair multiplexer 508 operates as a passthrough component. For example, the second repair multiplexer 508 does not switch between (1) the output of the second functional flip-flop 506 and (2) either of the shift_right or shift_left inputs during nominal operation. As described further herein, the first repair multiplexer 406 and the second repair multiplexer 508 can be used to repair a defective communication channel.

In the illustrated examples of FIGS. 4 and 5, the clock signal to the first functional flip-flop 408, the first testing flip-flop 418, and the first output flip-flop 426 is gated by the first clock gating circuitry 430. In the examples of FIGS. 4 and 5, the clock signal to the second functional flip-flop 506, the second testing flip-flop 526, and the second output flip-flop 534 is gated by the second clock gating circuitry 538. Additionally, the clock signal to the initialization flip-flop 514 is gated by the third clock gating circuitry 540.

In the illustrated examples of FIGS. 4 and 5, the clock signal to the first clock gating circuitry 430 is multiplexed between functional clock (e.g., the first clock TCLK) and the test clock (e.g., the second clock BIST_CLK_TX at a higher frequency than the first clock) via the fifth multiplexer 428. In the examples of FIGS. 4 and 5, the clock signal to the second clock gating circuitry 538 and the third clock gating circuitry 540 is multiplexed (e.g., by the eleventh multiplexer 536) between functional clock (e.g., the first clock TCLK) provided via the sixth buffer 520 and the test clock (e.g., the second clock BIST_CLK_RX at a higher frequency than the first clock). In examples disclosed herein, the signals to enable clock gating and perform clock selection in the transmit circuit 400 and the receive circuit 500 are generated by the clock control circuitry 304 and the clock control circuitry 314, respectively.

As described above, a communication channel between the transmit circuit 400 and the receive circuit 500 can be tested after respective dies including the transmit circuit 400 and the receive circuit 500 are coupled to the SiP 100. In the examples of FIGS. 4 and 5, the communication channel to be tested is between the first functional flip-flop 408, the first buffer 410, the third buffer 502, the fourth buffer 504, and the second functional flip-flop 506. To test the communication channel, the receiver control circuitry 120 utilizes the second testing circuit 522.

Before performing a test of a communication channel, the receiver control circuitry 120 initializes the receive circuit 500. For example, the test control circuitry 312 initializes the second functional flip-flop 506 and the second testing flip-flop 526. For example, the test control circuitry 312 initializes the second functional flip-flop 506 by setting the seventh multiplexer 512 to select the BIST_RX_SYNC_STIM_SHIFT_IN signal instead of the BIST_RX_SYNC_STIM_SHIFT_OUT signal (e.g., the output of the initialization flip-flop 514). As such, the initialization flip-flop 514 is loaded with an initial value as specified by the initial values register of the configuration register space 318. Thus, the initialization flip-flop 514 provides the second functional flip-flop 506 with the initial value (e.g., via the eighth multiplexer 516, the fifth buffer 518, and the fourth buffer 504). Additionally, the test control circuitry 312 initializes the second testing flip-flop 526 by setting the ninth multiplexer 524 to select the BIST_RX_SYNC_CHECK_SHIFT_IN signal instead of the output of the second testing flip-flop 526. As such, the second testing flip-flop 526 is loaded with an initial value as specified by the initial values register of the configuration register space 318.

Depending on whether the transmit circuit 400 and the receive circuit 500 are to act as victim or aggressor during the test, the initial values will be the same or opposite of the initial values in other instances of the receive circuit 500. For example, if the transmit circuit 400 and the receive circuit 500 are to act as victim during the test, then every other instance of the receive circuit 500 that is to act as an aggressor will have opposite initial values.

In the illustrated examples of FIGS. 4 and 5, initialization serves the purpose of making the input to the second functional flip-flop 506 and the second testing flip-flop 526 the same value before testing starts. Initialization is performed using the first clock (e.g., which has a first frequency less than the second frequency). In some examples, after initialization, the clock control circuitry 304 and the clock control circuitry 314 switch the first functional flip-flop 408, the second functional flip-flop 506, and the second testing flip-flop 526 from operating at the first frequency of the first clock to operating at the second frequency of the second clock.

To switch clocks, the clock control circuitry 304 disables the first clock and the second clock of the transmit circuit 400 and the clock control circuitry 314 disables the first clock and the second clock of the receive circuit 500. For example, the clock control circuitry 304 disables the first clock gating circuitry 430 (e.g., a switch). Additionally, the clock control circuitry 304 causes the first functional flip-flop 408 to operate at the second frequency of the second clock. For example, the clock control circuitry 304 causes the fifth multiplexer 428 to select the BIST_CLK_TX signal instead of the TCLK signal. The clock control circuitry 314 performs similar operations with respect to the second clock gating circuitry 538 and the eleventh multiplexer 536 to cause the second functional flip-flop 506 and the second testing flip-flop 526 to operate at the second frequency of the second clock.

In the illustrated examples of FIGS. 4 and 5, after switching the first functional flip-flop 408 from the first clock to the second clock, the clock control circuitry 304 enables the first clock and the second clock. For example, the clock control circuitry 304 enables the first clock gating circuitry 430 (e.g., a switch). Additionally, after switching the second functional flip-flop 506 and the second testing flip-flop 526 from the first clock to the second clock, the clock control circuitry 314 performs similar operations with respect to the second clock gating circuitry 538.

In examples disclosed herein, by gating the first clock and the second clock during switching, the clock control circuitry 304 and the clock control circuitry 314 prevent timing glitches from occurring during testing. In some examples, switching clocks can be omitted before testing. For example clock switching can be omitted depending on the latent fault(s) to be tested for during the test. As described above, by running a test at a slower clock speed, faults such as those illustrated in FIGS. 2A and 2B can be detected in addition to faults such as those illustrated in FIGS. 2C and 2D.

In the illustrated examples of FIGS. 4 and 5, after initialization and optionally after clock switch, the LFSR 306 injects a test pattern (e.g., a toggling pattern) into the transmit circuit 400. In the examples of FIGS. 4 and 5, the second testing flip-flop 526 generates a result to be compared by the second XOR gate 528 during the test. For example, the second testing flip-flop 526 generates a toggle pattern (e.g., a control pattern).

As such, the second testing flip-flop 526 generates a toggle pattern (e.g., a control pattern) for the duration of the test. The duration of the test is specified by the threshold register in the configuration register space 318. To control the test length, the clock control circuitry 314 un-gates the second clock gating circuitry 538 for the threshold number of clock cycles. In the examples of FIGS. 4 and 5, the threshold number of clock cycles is 64 cycles of the second clock. In some examples, the threshold number of clock cycles is based on an application in which the SiP 100 is to be used. For example, for applications where SiP 100 is to be always on, or frequently communicating (e.g., a networking application), then a longer period might be used for the threshold period. Additionally or alternatively, in an application where the SiP 100 may have less frequent communication (e.g., an automotive application), a shorter period might be used for the threshold than in other applications.

In the illustrated examples of FIGS. 4 and 5, the second XOR gate 528 compares the toggle pattern (e.g., a control pattern) against the test input signal (e.g., the BIST_RX_TO_MISR signal) coming from the second functional flip-flop 506. In the examples of FIGS. 4 and 5, if the two inputs to the second XOR gate 528 do not match, the second XOR gate 528 output a 1. In the examples of FIGS. 4 and 5, the second output flip-flop 534 is an error flop with an input that is multiplexed (e.g., by the tenth multiplexer 532) between the output of the second OR gate 530 and the output of the second testing flip-flop 526. During testing, the test control circuitry 312 sets the tenth multiplexer 532 to select the output of the second OR gate 530. If the comparison performed by the second XOR gate 528 fails (e.g., the output is a 1), then the second output flip-flop 534 logs an error bit as a 1. Additionally, the second OR gate 530 causes the error value to stick in the second output flip-flop 534.

In some examples, after testing, the clock control circuitry 304 and the clock control circuitry 314 switch the first functional flip-flop 408, the second functional flip-flop 506, and the second testing flip-flop 526 from operating at the second frequency of the second clock to operating at the first frequency of the first clock. To switch clocks, the clock control circuitry 304 disables the first clock and the second clock of the transmit circuit 400 and the clock control circuitry 314 disables the first clock and the second clock of the receive circuit 500. For example, the clock control circuitry 304 disables the first clock gating circuitry 430 (e.g., a switch). Additionally, the clock control circuitry 304 causes the first functional flip-flop 408 to operate at the first frequency of the first clock. For example, the clock control circuitry 304 causes the fifth multiplexer 428 to select the TCLK signal instead of the BIST_CLK_TX signal. The clock control circuitry 314 performs similar operations with respect to the second clock gating circuitry 538 and the eleventh multiplexer 536 to cause the second functional flip-flop 506 and the second testing flip-flop 526 to operate at the first frequency of the first clock.

In the illustrated examples of FIGS. 4 and 5, after switching the first functional flip-flop 408 from the second clock to the first clock, the clock control circuitry 304 enables the first clock. For example, the clock control circuitry 304 enables the first clock gating circuitry 430 (e.g., a switch). Additionally, after switching the second functional flip-flop 506 and the second testing flip-flop 526 from the second clock to the first clock, the clock control circuitry 314 performs similar operations with respect to the second clock gating circuitry 538.

In examples disclosed herein, by gating the first clock and the second clock during switching, the clock control circuitry 304 and the clock control circuitry 314 prevent timing glitches from occurring after testing. In some examples, switching clocks can be omitted after testing. For example clock switching can be omitted depending on the latent fault(s) tested for during the test. As described above, by running a test at a slower clock speed, faults such as those illustrated in FIGS. 2A and 2B can be detected in addition to faults such as those illustrated in FIGS. 2C and 2D.

In the illustrated examples of FIGS. 4 and 5, the test control circuitry 312 reads the second output flip-flop 534 to determine if there is an error on the communication channel. As described further herein, the test control circuitry 312 reads all of the output flip-flops of the receiver circuitry 118. The output flip-flops of the receiver circuitry 118 are referred to as the BIST chain because they form a chain of register that stitch together the output of the XOR gate comparisons for all communication channels to which the receiver circuitry 118 is coupled. By performing the BIST chain readout at the first frequency of the first clock, the test control circuitry 312 can traverses the many communication channels without experiencing timing issues.

Thus, as described above, a communication channel between the transmit circuit 400 and the receive circuit 500 can be tested after respective dies including the transmit circuit 400 and the receive circuit 500 are coupled to the SiP 100. Additionally, to test one or more of the transmit circuit 400 or the receive circuit 500 before respective dies including the transmit circuit 400 and the receive circuit 500 are coupled to the SiP 100, similar operations can be performed. For example, the transmitter control circuitry 116 can perform a similar test on the functional path between the first functional flip-flop 408 and the second buffer 412 by utilizing the first testing circuit 414. Additionally, the receiver control circuitry 120 can perform a similar test on the functional path between the third buffer 502, the fourth buffer 504, and the second functional flip-flop 506 by utilizing the second testing circuit 522.

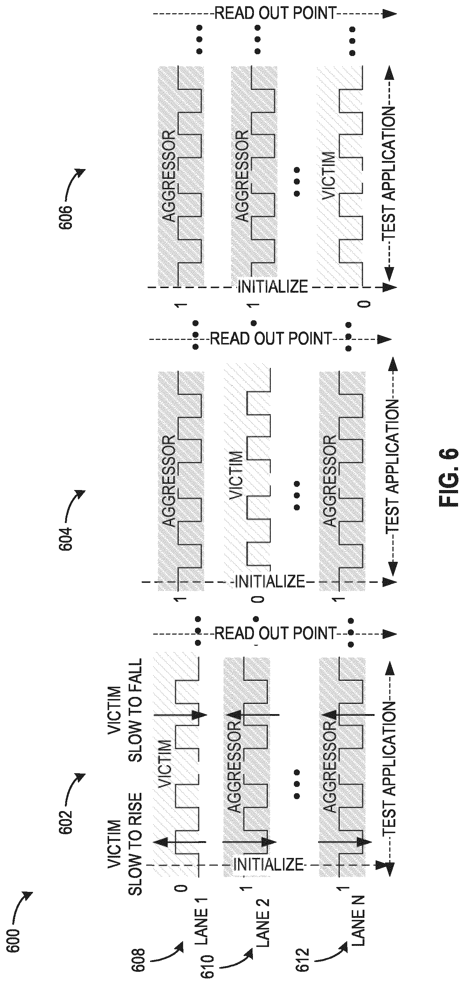

FIG. 6 is a graphical illustration 600 depicting first example patterns communicated between the first transmitter 102_{A} and the third receiver 104_{C} of FIG. 1 during victim aggressor rotational testing (VART). For example, disclosed VART can be conducted at full speed on-chip phase locked loop (PLL) oscillator frequencies. The graphical illustration 600 depicts a first example iteration 602 of VART, a second example iteration 604 of VART, and an Nth example iteration 606 of VART.

In each iteration of VART as illustrated in FIG. 6, one of the communication channels or lanes between the first transmitter 102_{A} and the third receiver 104_{C} is selected as a victim and the other communication channels are selected as aggressors. In examples disclosed herein communication channel and communication lane or lane are used interchangeably. During the first iteration 602, a first example lane 608 is the specified victim lane and a second example lane 610 through an Nth example lane 612 are aggressors. Additionally, during the first iteration 602, the transitions on the first lane 608 are 0-1-0-1 ...0-1 for an even number of clock cycles. During the clock cycles of the first iteration 602, the transitions on the rest of the lanes (e.g., the second lane 610 through the Nth lane 612) are 1-0-1-0 ... 1-0 for the same number of clock cycles.

In the illustrated example of FIG. 6, during the first iteration 602, one or more buffers of the transmit circuit that drives the first lane 608 (e.g., the victim lane) are subjected to the maximum electrical stress which maximizes the delay introduced in the signal transmitted over the first lane 608 as a result of capacitive coupling between lanes. The result of the first iteration 602 of example VART is read out on the BIST chain. For tests of communication channels (e.g., class tests), the receiver control circuitry 120 reads the BIST chain from the receiver circuitry 118. For tests of individual instances of the transmitter circuitry 114 or the receiver circuitry 118, the transmitter control circuitry 116 and the receiver control circuitry 120 read the BIST chain from the transmitter circuitry 114 and the receiver circuitry 118, respectively.

Example VART illustrated in FIG. 6 is repeated for *N* iterations where another lane is selected as the victim lane (e.g., the second lane 610 is the victim in the second iteration 604, the *N*th lane 612 is the victim in the *N*th iteration 606). As such, each communication channel between the first transmitter 102_{A} and the third receiver 104_{C} is subjected to the maximum electrical stress to determine if a latent fault manifests. As such, for *N* communication channels, VART includes *N* rounds, where one lane becomes the victim, and all other lanes are aggressors in each round. As illustrated in FIG. 6, victim lanes test application data toggles that have opposite phase with respect to all aggressor lanes. Example VART disclosed herein not only covers hard defects but also latent defects.

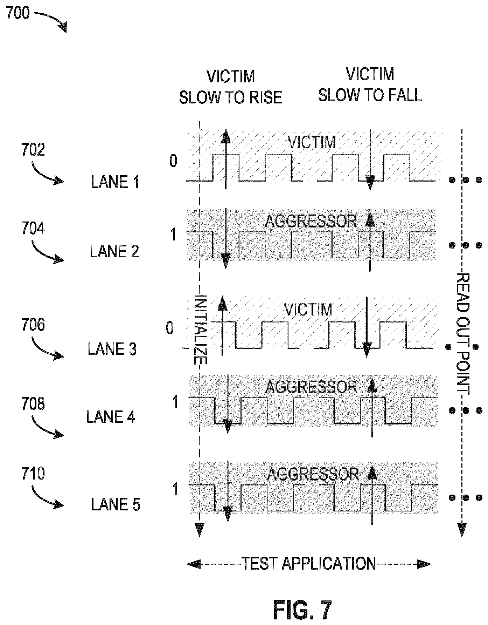

FIG. 7 is a graphical illustration 700 depicting second example patterns communicated between the first transmitter 102_{A} and the third receiver 104_{C} of FIG. 1 during selective victim aggressor testing (SVAT). For example, SVAT targets specific candidate coupling failures and can be used for debugging and failure analysis. In the example of FIG. 7, the graphical illustration 700 depicts one iteration of SVAT. In the example of FIG. 7, a first example lane 702 is a victim lane, a second example lane 704 is an aggressor lane, a third example lane 706 is a victim lane, a fourth example lane 708 is an aggressor lane, and a fifth example lane 710 is an aggressor lane.

For example, control circuitry (e.g., a microcontroller, a PMU or a PMC programmed by firmware, etc.) of the SiP 100 and/or an external testing controller (e.g., for debugging and/or failure analysis) can program one or more victim identity registers in the configuration register space 308 of the transmitter control circuitry 116 and/or one or more victim identity registers in the configuration register space 318 of the receiver control circuitry 120. To perform SVAT, the control circuitry and/or the external testing controller can program one or more lanes as a victim lane. As described above, SVAT allows for failure analysis to be performed to screen for latent faults with multiple lanes as the victim.

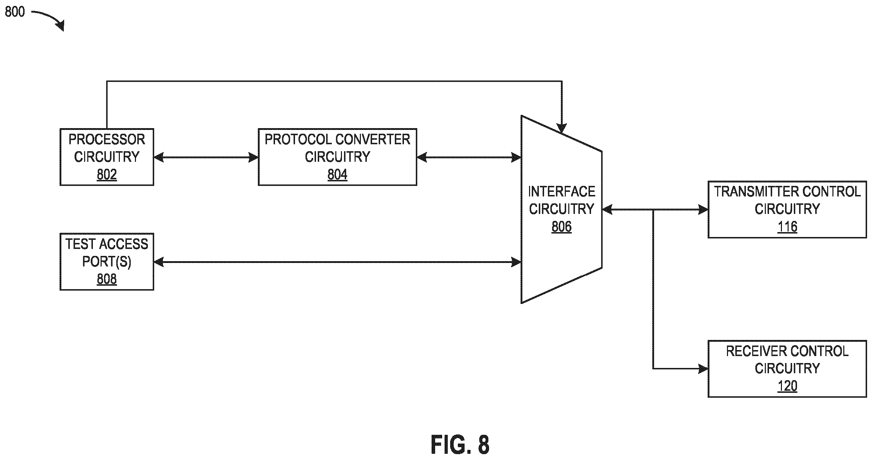

FIG. 8 is a block diagram of an example system 800 including example processor circuitry 802 and the transmitter control circuitry 116 and the receiver control circuitry 120 of FIG. 1. For example, the processor circuitry 802 is implemented by at least one of a microcontroller of the SiP 100 or a PMU or a PMC of the SiP 100 that is programmed by firmware. In some examples, the processor circuitry 802 is referred to as at least one processor circuit. During example communication, the processor circuitry 802 identifies a partition of the SiP 100 that is idle. For example, the processor circuitry 802 identifies the first transmitter 102_{A} and the third receiver 104_{C} as an idle partition.

In examples disclosed herein, by including an instance of the transmitter control circuitry 116 and an instance of the receiver control circuitry 120 in each die of the SiP 100, examples disclosed herein facilitate finding idle partitions. For example, instead of including one instance of the transmitter control circuitry 116 and one instance of the receiver control circuitry 120 per clock domain (which may include one or several partitions and therefore be difficult to identify as idle), examples disclosed herein include respective instances of the transmitter control circuitry 116 and the receiver control circuitry 120 in each die. As such, examples disclosed herein improve infield testing.

In the illustrated example of FIG. 8, after identifying an idle partition, the processor circuitry 802 programs the transmitter control circuitry 116 and the receiver control circuitry 120 to perform a test over a threshold number of clock cycles. In the example of FIG. 8, the processor circuitry 802 programs the transmitter control circuitry 116 and the receiver control circuitry 120 via example protocol converter circuitry 804 and example interface circuitry 806. For example, the processor circuitry 802 is configured to communicate according to firmware protocol such as the advanced peripheral bus (APB) protocol, the advanced extensible interface (AXI) protocol, or a sideband protocol. Also, for example, the transmitter control circuitry 116 and the receiver control circuitry 120 are configured to communicate according to an integrated testing model such as the integrated testing model defined by the Joint Test Action Group (JTAG).

As such, the protocol converter circuitry 804 converts firmware commands from the processor circuitry 802 to test access port (TAP) commands to be utilized by one or more of the transmitter control circuitry 116 or the receiver control circuitry 120. Additionally, in the example of FIG. 8, the interface circuitry 806 multiplexes between the output of the protocol converter circuitry 804 and one or more example test access ports (TAPs) 808. For example, the one or more TAPs 808 allows for an external testing controller to program one or more of the transmitter control circuitry 116 or the receiver control circuitry 120.

In the illustrated example of FIG. 8, in addition to programming the threshold number of clock cycles, the processor circuitry 802 generates a transaction to set a start bit (e.g., one or more initial values) in the transmitter control circuitry 116. As such, the transmitter control circuitry 116 generates test data for the threshold number of clock cycles utilizing the LFSR 306 as described above. Additionally, the receiver control circuitry 120 receives the test data into the MISR 316 for the threshold number of clock cycles.

In the illustrated example of FIG. 8, after the threshold number of clock cycles expires, both the transmitter control circuitry 116 and the receiver control circuitry 120 set the a "test done" bit in respective test status registers. In the example of FIG. 8, the test control circuitry 312 of the receiver control circuitry 120 reads the BIST chain of a corresponding instance of the receiver circuitry 118. In the example of FIG. 8, if the test passes the test control circuitry 312 of the receiver control circuitry 120 sets the one or more debug registers to all 1's (e.g., a reset value). For example, the reset value is all 1's and not all 0's because 0 is a valid identity of a communication channel.

In the illustrated example of FIG. 8, if any of the output flip-flops of the corresponding instance of the receiver circuitry 118 are set, the test control circuitry 312 of the receiver control circuitry 120 sets one or more of the debug registers in the configuration register space 318. As such, the receiver control circuitry 120 identifies, to the processor circuitry 802, the potentially defective communication channel(s) corresponding to the set output flip-flop(s). Additionally, the receiver control circuitry 120 sets a bit to indicate whether the test passed or failed in the test result register of the configuration register space 318.

For example, for a cluster of communication channels including ten channels, then VART performed by the processor circuitry 802, the transmitter control circuitry 116, and the receiver control circuitry 120 will include ten rounds. If there is a static defect present on lanes three and four and if, during the first round of VART, the receiver control circuitry 120 detects a cross talk latent defect on lane zero, then the receiver control circuitry 120 will set three debug registers, one for lane zero, one for lane three, and one for lane four. As such, the processor circuitry 802 can identify lane zero, lane three, and lane four as defective and program one or more repair registers to repair lane zero, lane three, and lane four.

Additionally, for example, for a cluster of communication channels including ten channels, then VART performed by the processor circuitry 802, the transmitter control circuitry 116, and the receiver control circuitry 120 will include ten rounds. If there is a static defect present on lanes three and four and if, during the fifth round of VART, the receiver control circuitry 120 detects a cross talk latent defect on lane five, then the receiver control circuitry 120 will set three debug registers, one for lane three, one for lane four, and one for lane five. As such, the processor circuitry 802 can identify lane three, lane four, and lane five as defective and program one or more repair registers to repair lane three, lane four, and lane five. As described above, example VART disclosed herein not only covers hard defects but also latent defects. As such, examples disclosed herein improve infield scan testing from detecting about 85% of faults to detecting about 100% of faults (e.g., latent or otherwise).

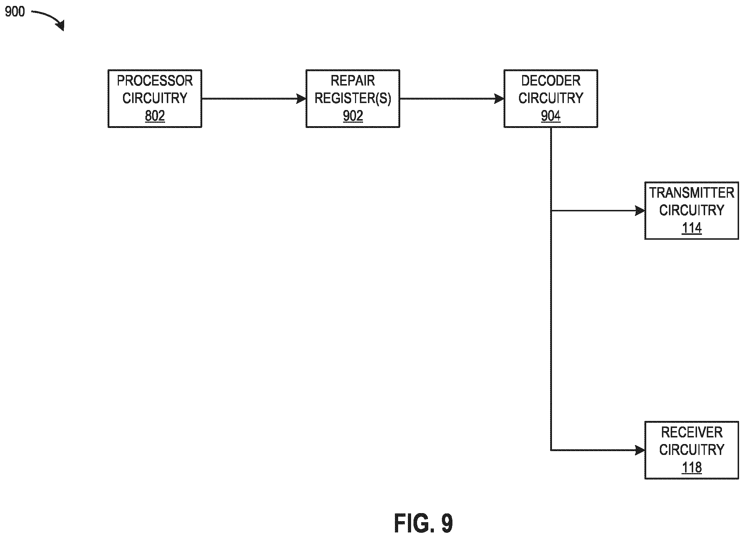

FIG. 9 is a block diagram of an example system 900 including the example processor circuitry 802 of FIG. 8 and one or more of the example transmitter circuitry 114 or the example receiver circuitry 118 of FIG. 1 to repair a defective communication channel. In the example of FIG. 9, if a test fails, then the processor circuitry 802 repairs one or more defective communication channels if one or more repair or redundant communication channels or lanes are provided. For example, a partition including 56 lanes also includes one redundant lane for purposes of repairing a defective lane.

In the illustrated example of FIG. 9, to cause the transmitter circuitry 114 and the receiver circuitry 118 to substitute a defective communication channel with a redundant communication channel, the processor circuitry 802 programs one or more example repair registers 902 of the SiP 100. For example, the processor circuitry 802 identifies one or more defective lanes by reading one or more debug registers via the protocol converter circuitry 804 and the interface circuitry 806. Based on the value(s) of the one or more debug registers, the processor circuitry 802 programs the one or more repair registers 902 via the protocol converter circuitry 804 and the interface circuitry 806. In the example of FIG. 9, example decoder circuitry 904 of the SiP 100 reads the value(s) of the one or more repair registers 902.

Based on the value(s) of the one or more repair registers 902, the decoder circuitry 904 provides values to the select lines of repair multiplexers (e.g., respective multiplexers) of the transmitter circuitry 114 and the receiver circuitry 118 (e.g., the first repair multiplexer 406 and the second repair multiplexer 508). In the example of FIG. 9, the decoder circuitry 904 controls the repair multiplexers to shift signals to the left or to the right based on the location of the defective communication channel. For example, if a cluster of communication channels includes nine functional lanes and two redundant lanes, then the layout of the lanes is as follows: Repair Lane 0, Functional Lane 0, Functional Lane 1, Functional Lane 2, Functional Lane 3, Functional Lane 4, Functional Lane 5, Functional Lane 6, Functional Lane 7, Functional Lane 8, Repair Lane 1.

If, for example, there is a failure on Functional Lane 1, then the decoder circuitry 904 sends, based on the value of the one or more repair registers 902, select signals to the repair multiplexers of the transmit and receive circuits corresponding to Functional Lane 1 and Functional Lane 0 to shift respective signals conducted over the functional lanes left onto Repair Lane 0. Additionally, if, for example, there is a failure on Functional Lane 7, then the decoder circuitry 904 sends, based on the value of the one or more repair registers 902, select signals to the repair multiplexers of the transmit and receive circuits corresponding to Functional Lane 7 and Functional Lane 8 to shift respective signals conducted over the functional lanes right onto Repair Lane 1.

In the above-described examples, the number of available repair lanes is two. As such, if there are two failing lanes and the number of repair lanes is two, then the receiver control circuitry 120 sets two debug registers to identify the two failing lanes. Additionally, the above-described examples are for purposes of understanding how examples disclosed herein repair defective communication channels. It should be understood that the number of lanes in a cluster of communication channels may be significantly larger. For example, the number of lanes could be large as 312 lanes per cluster and as large as 742,000 lanes in an SiP having 128 processor cores.

In the illustrated example of FIG. 9, the decoder circuitry 904 repairs defective communication channels while a partition is idle or offline. In additional or alternative examples, the decoder circuitry 904 repairs defective communication channels during runtime and/or while the SiP 100 is deployed in-field. For example, after initial programming of the one or more repair registers 902, the decoder circuitry 904 stores values for the select lines of repair multiplexers in retention registers that maintain their value even during power down and/or power off cycles. For example, the retention registers are implemented by one or more set-reset (SR) latches or SR flip-flops.

As such, after initial programming of the one or more repair registers 902, the decoder circuitry 904 can repair a defective communication channel without interacting with another device (e.g., the processor circuitry 802). In some examples, the receiver control circuitry 120 programs one or more debug registers when a partition comes online (e.g., is powered on). As such, when a partition comes online, the processor circuitry 802 reads the value(s) of the one or more debug registers and programs the one or more repair registers 902 via the protocol converter circuitry 804 and the interface circuitry 806.

In some examples, the processor circuitry 802 is instantiated by programmable circuitry executing test and repair instructions and/or configured to perform operations such as those represented by the flowchart(s) of FIG. 12. In some examples, the system 800 and/or the system 900 includes means for testing and repairing communication channels. For example, the means for testing and comparing may be implemented by the processor circuitry 802. In some examples, the processor circuitry 802 may be instantiated by programmable circuitry such as the example programmable circuitry 1612 of FIG. 16. For instance, the processor circuitry 802 may be instantiated by the example microprocessor 1700 of FIG. 17 executing machine executable instructions such as those implemented by at least blocks 1202, 1204, 1206, 1208, 1210, 1212, 1214, and 1216 of FIG. 12.

In some examples, the processor circuitry 802 may be instantiated by hardware logic circuitry, which may be implemented by an ASIC, XPU, or the FPGA circuitry 1800 of FIG. 18 configured and/or structured to perform operations corresponding to the machine-readable instructions. Additionally or alternatively, the processor circuitry 802 may be instantiated by any other combination of hardware, software, and/or firmware. For example, the processor circuitry 802 may be implemented by at least one or more hardware circuits (e.g., processor circuitry, discrete and/or integrated analog and/or digital circuitry, an FPGA, an ASIC, an XPU, a comparator, an operational-amplifier (op-amp), a logic circuit, etc.) configured and/or structured to execute some or all of the machine readable instructions and/or to perform some or all of the operations corresponding to the machine readable instructions without executing software or firmware, but other structures are likewise appropriate.

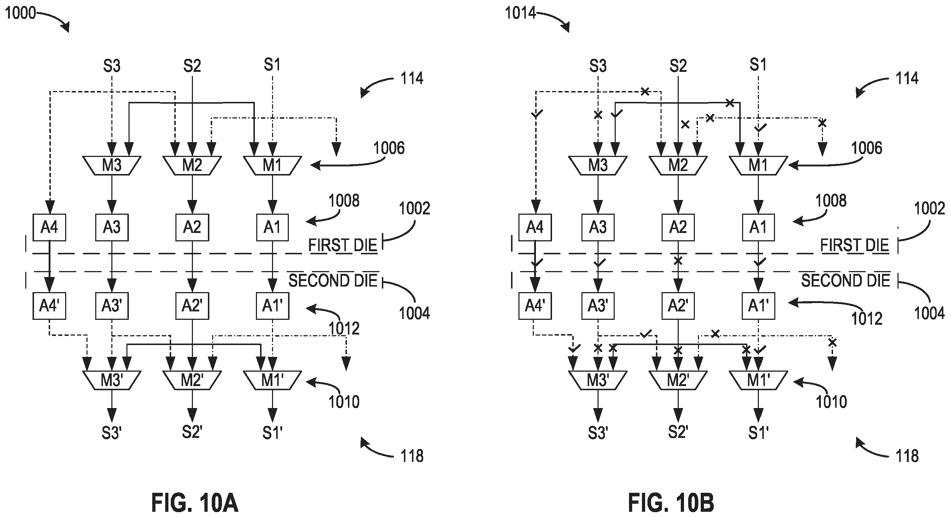

FIG. 10A is a block diagram 1000 illustrating example communication between the transmitter circuitry 114 and the receiver circuitry 118 of FIG. 1 before a fault is detected. In the example of FIG. 10A, the block diagram 1000 illustrates a cluster of communication channels between a first example die 1002 and a second example die 1004. For example, the first die 1002 implements the transmitter circuitry 114 and the second die 1004 implements the receiver circuitry 118. In the example of FIG. 10A, the transmitter circuitry 114 includes first example repair multiplexers 1006 (e.g., similar to the first repair multiplexer 406) before first example pads 1008 of the first die 1002. Additionally, the receiver circuitry 118 includes second example repair multiplexers 1010 (e.g., similar to the second repair multiplexer 508) after second example pads 1012 of the second die 1004.

In the illustrated example of FIG. 10A, the first pads 1008 include a first transmit pad A1, a second transmit pad A2, a third transmit pad A3, and a fourth transmit pad A4. In the example of FIG. 10A, the first pads 1008 are associated with the first repair multiplexers 1006 which include a first transmit repair multiplexer M1, a second transmit repair multiplexer M2, and a third transmit repair multiplexer M3. Additionally, the second pads 1012 include a first receive pad A1', a second receive pad A2', a third receive pad A3', and a fourth receive pad A4'. In the example of FIG. 10A, the second pads 1012 are associated with the second repair multiplexers 1010 which include a first receive repair multiplexer M1', a second receive repair multiplexer M2', and a third receive repair multiplexer M3'.

In the illustrated example of FIG. 10A, each of the first repair multiplexers 1006 routes one of three transmit signals (e.g., a first transmit signal S1, a second transmit signal S2, and a third transmit signal S3) through respective ones of the first pads 1008. For example, the second transmit repair multiplexer M2 can drive, through the second transmit pad A2, the second transmit signal S2. In some examples, the second transmit repair multiplexer M2 can drive, through the second transmit pad A2, the third transmit signal S3 from the left of the second transmit repair multiplexer M2 or the first transmit signal S1 from the right of the second transmit repair multiplexer M2 depending on one or more select line values (e.g., set by the decoder circuitry 904).

In the illustrated example of FIG. 10A, on the second die 1004, each of the second repair multiplexer 1010 routes one of three receive signals (e.g., a first receive signal S1', a second receive signal S2', and a third receive signal S3') from respective ones of the second pads 1012. For example, the second receive repair multiplexer M2' can route the second receive signal S2' from the second receive pad A2'. In some examples, the second receive repair multiplexer M2' can route the third receive signal S3' from the third receive pad A3' to the left of the second receive repair multiplexer M2' or the first receive signal S1' from first receive pad A1' to the right of the second receive repair multiplexer M2'.

In the illustrated example of FIG. 10A, during nominal operation (e.g., before a fault in a communication channel is detected), the first transmit repair multiplexer M1 routes the first transmit signal S1 to the first transmit pad A1. Additionally, during nominal operation, the first receive repair multiplexer M1' routes the first receive signal S1' from the first receive pad A1'. In the example of FIG. 10A, during nominal operation, the second transmit repair multiplexer M2 routes the second transmit signal S2 to the second transmit pad A2. Additionally, during nominal operation, the second receive repair multiplexer M2' routes the second receive signal S2' from the second receive pad A2'.

In the illustrated example of FIG. 10A, during nominal operation, the third transmit repair multiplexer M3 routes the third transmit signal S3 to the third transmit pad A3. Additionally, during nominal operation, the third receive repair multiplexer M3' routes the third receive signal S3' from the third receive pad A3'. In the example of FIG. 10A, the fourth transmit pad A4 and the fourth receive pad A4' offer a redundant communication channel.

FIG. 10B is a block diagram 1014 illustrating example communication between the transmitter circuitry 114 and the receiver circuitry 118 of FIG. 1 after the fault is repaired. For example, if a fault occurs on the communication channel between the second transmit pad A2 and the second receive pad A2', then the decoder circuitry 904 sets select signals for the first repair multiplexers 1006 to shift the second transmit signal S2 left and through the third transmit repair multiplexer M3 to avoid the defective communication channel. Also, the decoder circuitry 904 sets select signals for the first repair multiplexers 1006 to shift the third transmit signal S3 left and through the fourth transmit pad A4 and the fourth receive pad A4'.

Additionally, on the second die 1004, the decoder circuitry 904 sets select signals for the second repair multiplexers 1010 to shift the second receive signal S2' right from the third receive pad A3' and through the second receive repair multiplexer M2'. Also, the decoder circuitry 904 sets select signals for the second repair multiplexers 1010 to shift the third receive signal S3' right from the fourth receive pad A4' and through the third receive repair multiplexer M3'. As such, the communication path for the second transmit signal S2 and the second receive signal S2' is reconfigured to avoid the defective communication channel between the second transmit pad A2 and the second receive pad A2'. Additionally, the second transmit signal S2 and the second receive signal S2' remain connected to retain the native functionality of the circuit.

Similarly, the communication path for the third transmit signal S3 and the third receive signal S3' is reconfigured to utilize the redundant communication channel between the fourth transmit pad A4 and the fourth receive pad A4'. Additionally, the third transmit signal S3 and the third receive signal S3' remain connected to retain the native functionality of the circuit. As described above, the processor circuitry 802 can program the one or more repair registers 902 based on values set in the one or more debug registers by the receiver control circuitry 120.

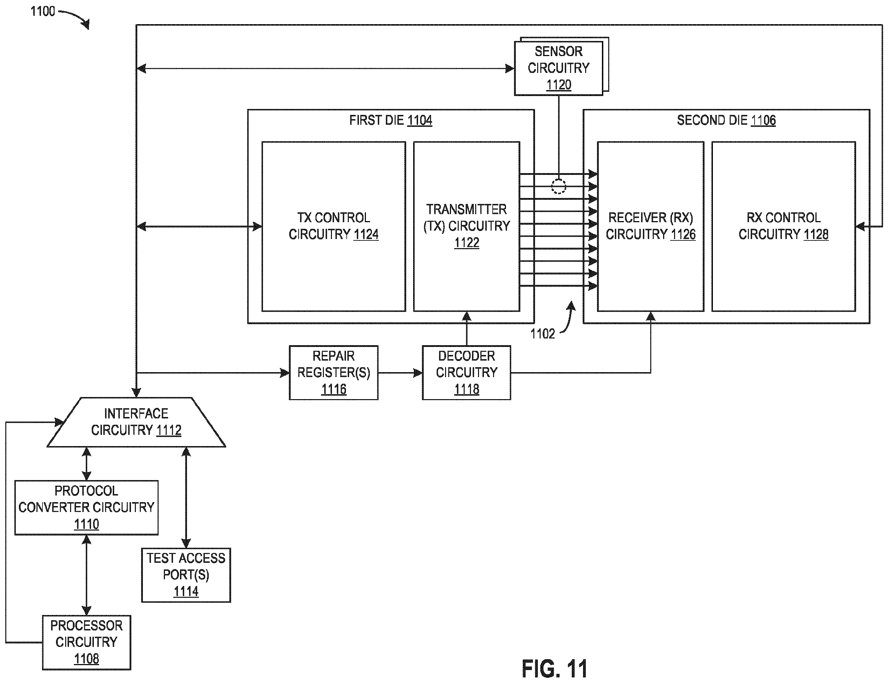

FIG. 11 is a block diagram of an example system 1100 to proactively repair example communication channels 1102 before a latent fault occurs. In the example of FIG. 11, the system 1100 includes the example communication channels 1102, a first example die 1104, a second example die 1106, example processor circuitry 1108, example protocol converter circuitry 1110, example interface circuitry 1112, and one or more example test access ports (TAPs) 1114. Additionally, the system 1100 includes one or more example repair registers 1116, example decoder circuitry 1118, and example sensor circuitry 1120. In the example of FIG. 11, the first die 1104 includes example transmitter circuitry 1122 and example transmitter control circuitry 1124. Additionally, the second die 1106 includes example receiver circuitry 1126 and example receiver control circuitry 1128.

In the illustrated example of FIG. 11, the first die 1104 and the second die 1106 are implemented by the first die 106 and the second die 108 of FIG. 1. In the example of FIG. 11, the transmitter circuitry 1122 and the transmitter control circuitry 1124 are implemented by the transmitter circuitry 114 and the transmitter control circuitry 116 of FIG. 1. Additionally, the receiver circuitry 1126 and the receiver control circuitry 1128 of FIG. 11 are implemented by the receiver circuitry 118 and the receiver control circuitry 120 of FIG. 1. In the example of FIG. 11, the processor circuitry 1108, the protocol converter circuitry 1110, the interface circuitry 1112, and the one or more TAPs 1114 are implemented by the processor circuitry 802, the protocol converter circuitry 804, the interface circuitry 806, and the one or more TAPs 808 of FIG. 8. Additionally, the one or more repair registers 1116 and the decoder circuitry 1118 are implemented by the one or more repair registers 902 and the decoder circuitry 904 of FIG. 9.

In the illustrated example of FIG. 11, each of the communication channels 1102 can be monitored using intelligent sensor circuitry. For example, a first one of the communication channels 1102 is monitored by the sensor circuitry 1120. In the example of FIG. 11, a communication channel to be monitored is selected (e.g., during design of the system 1100) based on the functional traffic that the communication channel is to conduct after deployment. For example, if a communication channel is to be used in an application that requires the communication channel to have more than a threshold setup timing margin, then the communication channel can be selected for monitoring. For example, timing margins for specific communication channels can be determined during a design and/or manufacturing phase of development of an SiP. In some examples, timing margins for specific communication channels can be determined during runtime deployment. As such, communication channels can be selected for monitoring dynamically in the field.

In the illustrated example of FIG. 11, the processor circuitry 1108 sets, via the protocol converter circuitry 1110 and the interface circuitry 1112, a threshold margin for the sensor circuitry 1120. In the example of FIG. 11, the threshold margin is associated with performance of the communication channel to be monitored. For example, the threshold margin is based on one or more of (a) process technology used to fabricate at least one of the transmitter circuitry 1122 (e.g., the transmitter), the receiver circuitry 1126 (e.g., the receiver), or the communication channel to be monitored, (b) historical data associated with an application for which the communication channel is to be utilized, or (c) performance (e.g., runtime data) of at least one of the transmitter circuitry 1122 (e.g., the transmitter), the receiver circuitry 1126 (e.g., the receiver), or the communication channel. As such, when the sensor circuitry 1120 indicates that the threshold margin has been satisfied, the processor circuitry 1108 can program, via the protocol converter circuitry 1110 and the interface circuitry 1112, the one or more repair registers 1116 to cause the decoder circuitry 1118 to prepare the communication channel before a latent fault occurs.

In examples disclosed herein, the width of the one or more repair registers 1116 is equal to the number of lanes in the communication channels 1102. For example, if there are ten lanes in the communication channels 1102, then the one or more repair registers 1116 is a 10-bit register. In the example of FIG. 11, the sensor circuitry 1120 can be implemented by a variety of sensors depending on the quantity to be monitored. For communication channels with sensitive timing margins, the sensor circuitry 1120 is implemented by a timing margin sensor (TMS). For example, a TMS can be used to monitor the setup margin of a timing path. Additionally or alternatively, for communication channels with sensitive voltage margins, the sensor circuitry 1120 is implemented by a voltage glitch sensor. In some examples, the sensor circuitry 1120 implements multiple sensors that can each individually monitor a separate communication channel.

In the illustrated example of FIG. 11, the communication channels 1102 include eight functional lanes and two repair lanes. In the example of FIG. 11, lane 0 has a very tight setup timing margin of +15 picoseconds (ps) and hence lane 0 is monitored with a TMS connected to lane 0. In the example of FIG. 11, the processor circuitry 1108 sets the threshold margin for the sensor circuitry 1120 to 5 ps based on previous silicon data. After some time during operation of the system 1100, the sensor circuitry 1120 detects that the timing margin on lane 0 has reached the threshold margin of 5 ps. As such, the sensor circuitry 1120 sends an interrupt, via the interface circuitry 1112 and the protocol converter circuitry 1110, to the processor circuitry 1108.

In the illustrated example of FIG. 11, the processor circuitry 1108 reads the interrupt, which indicates that the timing margin on lane 0 has reached 5 ps. Based on the interrupt (e.g., which is associated with satisfaction of the threshold margin), the processor circuitry 1108 sets a bit in the one or more repair registers corresponding to lane 0 and the decoder circuitry 1118 repairs the communication channels 1102 to avoid lane 0 as described herein. As described above, examples disclosed herein intercept intelligent sensor data for prediction of failure related to transient faults and perform repair even before failure occurs. Thus, in addition to detecting catastrophic faults on any functional lane, examples disclosed herein include advanced monitoring techniques based on intelligent sensors. As such, examples disclosed herein advantageously provide a capability of detecting a marginal functional lane (e.g., a functional lane that is likely to experience a latent or transient fault and may degrade over time to eventually fail). By detecting a marginal lane and repairing the marginal lane before failure occurs, examples disclosed herein increase the availability of SiPs.

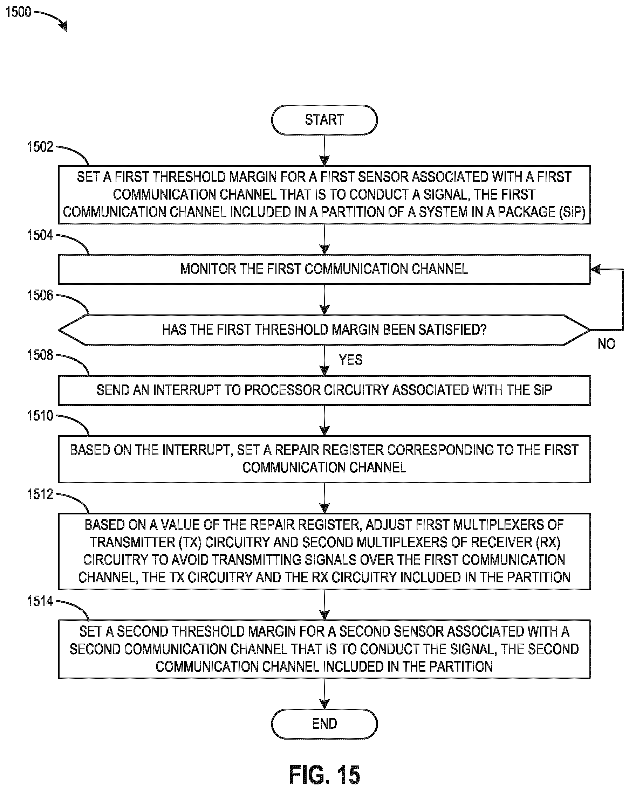

In some examples, the processor circuitry 1108 is instantiated by programmable circuitry executing predictive test and repair instructions and/or configured to perform operations such as those represented by the flowchart(s) of FIG. 15. In some examples, the system 1100 includes means for predictive testing and repairing communication channels. For example, the means for predictive testing and comparing may be implemented by the processor circuitry 1108. In some examples, the processor circuitry 1108 may be instantiated by programmable circuitry such as the example programmable circuitry 1612 of FIG. 16. For instance, the processor circuitry 1108 may be instantiated by the example microprocessor 1700 of FIG. 17 executing machine executable instructions such as those implemented by at least blocks 1502, 1510, and 1514 of FIG. 15.

In some examples, the processor circuitry 1108 may be instantiated by hardware logic circuitry, which may be implemented by an ASIC, XPU, or the FPGA circuitry 1800 of FIG. 18 configured and/or structured to perform operations corresponding to the machine-readable instructions. Additionally or alternatively, the processor circuitry 1108 may be instantiated by any other combination of hardware, software, and/or firmware. For example, the processor circuitry 1108 may be implemented by at least one or more hardware circuits (e.g., processor circuitry, discrete and/or integrated analog and/or digital circuitry, an FPGA, an ASIC, an XPU, a comparator, an operational-amplifier (op-amp), a logic circuit, etc.) configured and/or structured to execute some or all of the machine readable instructions and/or to perform some or all of the operations corresponding to the machine readable instructions without executing software or firmware, but other structures are likewise appropriate.

In some examples, the sensor circuitry 1120 is instantiated by programmable circuitry executing sensing instructions and/or configured to perform operations such as those represented by the flowchart(s) of FIG. 15. In some examples, the system 1100 includes means for sensing a value. For example, the means for sensing may be implemented by the sensor circuitry 1120. In some examples, the sensor circuitry 1120 may be instantiated by programmable circuitry such as the example programmable circuitry 1612 of FIG. 16. For instance, the sensor circuitry 1120 may be instantiated by the example microprocessor 1700 of FIG. 17 executing machine executable instructions such as those implemented by at least blocks 1504, 1506, and 1508 of FIG. 15.

In some examples, the sensor circuitry 1120 may be instantiated by hardware logic circuitry, which may be implemented by an ASIC, XPU, or the FPGA circuitry 1800 of FIG. 18 configured and/or structured to perform operations corresponding to the machine-readable instructions. Additionally or alternatively, the sensor circuitry 1120 may be instantiated by any other combination of hardware, software, and/or firmware. For example, the sensor circuitry 1120 may be implemented by at least one or more hardware circuits (e.g., processor circuitry, discrete and/or integrated analog and/or digital circuitry, an FPGA, an ASIC, an XPU, a comparator, an operational-amplifier (op-amp), a logic circuit, etc.) configured and/or structured to execute some or all of the machine readable instructions and/or to perform some or all of the operations corresponding to the machine readable instructions without executing software or firmware, but other structures are likewise appropriate.

In some examples, the decoder circuitry 1118 is instantiated by programmable circuitry executing decoding instructions and/or configured to perform operations such as those represented by the flowchart(s) of FIG. 15. In some examples, the system 1100 includes means for decoding a repair register. For example, the means for decoding may be implemented by the decoder circuitry 1118. In some examples, the decoder circuitry 1118 may be instantiated by programmable circuitry such as the example programmable circuitry 1612 of FIG. 16. For instance, the decoder circuitry 1118 may be instantiated by the example microprocessor 1700 of FIG. 17 executing machine executable instructions such as those implemented by at least block 1512 of FIG. 15.

In some examples, the decoder circuitry 1118 may be instantiated by hardware logic circuitry, which may be implemented by an ASIC, XPU, or the FPGA circuitry 1800 of FIG. 18 configured and/or structured to perform operations corresponding to the machine-readable instructions. Additionally or alternatively, the decoder circuitry 1118 may be instantiated by any other combination of hardware, software, and/or firmware. For example, the decoder circuitry 1118 may be implemented by at least one or more hardware circuits (e.g., processor circuitry, discrete and/or integrated analog and/or digital circuitry, an FPGA, an ASIC, an XPU, a comparator, an operational-amplifier (op-amp), a logic circuit, etc.) configured and/or structured to execute some or all of the machine readable instructions and/or to perform some or all of the operations corresponding to the machine readable instructions without executing software or firmware, but other structures are likewise appropriate.

While an example manner of implementing the transmitter control circuitry 116 of FIG. 1 is illustrated in FIG. 3A, one or more of the elements, processes, and/or devices illustrated in FIG. 3A may be combined, divided, re-arranged, omitted, eliminated, and/or implemented in any other way. Additionally, while an example manner of implementing the receiver control circuitry 120 of FIG. 1 is illustrated in FIG. 3B, one or more of the elements, processes, and/or devices illustrated in FIG. 3B may be combined, divided, re-arranged, omitted, eliminated, and/or implemented in any other way. While an example manner of implementing the system 800 of FIG. 8 is illustrated in FIG. 8, one or more of the elements, processes, and/or devices illustrated in FIG. 8 may be combined, divided, re-arranged, omitted, eliminated, and/or implemented in any other way.

While an example manner of implementing the system 900 of FIG. 9 is illustrated in FIG. 9, one or more of the elements, processes, and/or devices illustrated in FIG. 9 may be combined, divided, re-arranged, omitted, eliminated, and/or implemented in any other way. Additionally, an example manner of implementing the system 1100 of FIG. 11 is illustrated in FIG. 11, one or more of the elements, processes, and/or devices illustrated in FIG. 11 may be combined, divided, re-arranged, omitted, eliminated, and/or implemented in any other way. Further, the example test control circuitry 302, the example clock control circuitry 304, the example LFSR 306, the example configuration register space 308, and/or, more generally, the transmitter control circuitry 116 of FIG. 3A and/or the example test control circuitry 312, the example clock control circuitry 314, the example MISR 316, the example configuration register space 318, and/or, more generally, the receiver control circuitry 120 of FIG. 3B and/or the example processor circuitry 802, the example protocol converter circuitry 804, the example interface circuitry 806, the one or more example TAPs 808, and/or, more generally, the system 800 of FIG. 8 and/or the one or more example repair registers 902, the decoder circuitry 904, and/or, more generally, the system 900 of FIG. 9 and/or the first example die 1104, the second example die 1106, the example processor circuitry 1108, the example protocol converter circuitry 1110, the example interface circuitry 1112, the one or more examples TAPs 1114, the one or more example repair registers 1116, the example decoder circuitry 1118, the example sensor circuitry 1120, the example transmitter circuitry 1122, the example transmitter control circuitry 1124, the example receiver circuitry 1126, the example receiver control circuitry 1128, and/or, more generally, the system 1100 of FIG. 11, may be implemented by hardware alone or by hardware in combination with software and/or firmware.

Thus, for example, any of t the example test control circuitry 302, the example clock control circuitry 304, the example LFSR 306, the example configuration register space 308, and/or, more generally, the transmitter control circuitry 116 of FIG. 3A and/or the example test control circuitry 312, the example clock control circuitry 314, the example MISR 316, the example configuration register space 318, and/or, more generally, the receiver control circuitry 120 of FIG. 3B and/or the example processor circuitry 802, the example protocol converter circuitry 804, the example interface circuitry 806, the one or more example TAPs 808, and/or, more generally, the system 800 of FIG. 8 and/or the one or more example repair registers 902, the decoder circuitry 904, and/or, more generally, the system 900 of FIG. 9 and/or the first example die 1104, the second example die 1106, the example processor circuitry 1108, the example protocol converter circuitry 1110, the example interface circuitry 1112, the one or more examples TAPs 1114, the one or more example repair registers 1116, the example decoder circuitry 1118, the example sensor circuitry 1120, the example transmitter circuitry 1122, the example transmitter control circuitry 1124, the example receiver circuitry 1126, the example receiver control circuitry 1128, and/or, more generally, the system 1100 of FIG. 11, could be implemented by programmable circuitry in combination with machine readable instructions (e.g., firmware or software), processor circuitry, analog circuit(s), digital circuit(s), logic circuit(s), programmable processor(s), programmable microcontroller(s), graphics processing unit(s) (GPU(s)), digital signal processor(s) (DSP(s)), ASIC(s), programmable logic device(s) (PLD(s)), and/or field programmable logic device(s) (FPLD(s)) such as FPGAs. Further still, the example transmitter control circuitry 116 of FIG. 3A, the example receiver control circuitry 120 of FIG. 3B, the example system 800 of FIG. 8, the example system 900 of FIG. 9, and/or the example system 1100 of FIG. 11 may include one or more elements, processes, and/or devices in addition to, or instead of, those illustrated in FIGS. 3A, 3B, 8, 9, and/or 11, and/or may include more than one of any or all of the illustrated elements, processes and devices.

Flowchart(s) representative of example machine readable instructions, which may be executed by programmable circuitry to implement and/or instantiate the example transmitter control circuitry 116 of FIG. 3A, the example receiver control circuitry 120 of FIG. 3B, the example system 800 of FIG. 8, the example system 900 of FIG. 9, and/or the example system 1100 of FIG. 11 and/or representative of example operations which may be performed by programmable circuitry to implement and/or instantiate the example transmitter control circuitry 116 of FIG. 3A, the example receiver control circuitry 120 of FIG. 3B, the example system 800 of FIG. 8, the example system 900 of FIG. 9, and/or the example system 1100 of FIG. 11, are shown in FIGS. 12, 13, 14, and 15. The machine readable instructions may be one or more executable programs or portion(s) of one or more executable programs for execution by programmable circuitry such as the programmable circuitry 1612 shown in the example programmable circuitry platform 1600 discussed below in connection with FIG. 16 and/or may be one or more function(s) or portion(s) of functions to be performed by the example programmable circuitry (e.g., an FPGA) discussed below in connection with FIGS. 17 and/or 18. In some examples, the machine readable instructions cause an operation, a task, etc., to be carried out and/or performed in an automated manner in the real world. As used herein, "automated" means without human involvement.

The program may be embodied in instructions (e.g., software and/or firmware) stored on one or more non-transitory computer readable and/or machine readable storage medium such as cache memory, a magnetic-storage device or disk (e.g., a floppy disk, a Hard Disk Drive (HDD), etc.), an optical-storage device or disk (e.g., a Blu-ray disk, a Compact Disk (CD), a Digital Versatile Disk (DVD), etc.), a Redundant Array of Independent Disks (RAID), a register, ROM, a solid-state drive (SSD), SSD memory, non-volatile memory (e.g., electrically erasable programmable read-only memory (EEPROM), flash memory, etc.), volatile memory (e.g., Random Access Memory (RAM) of any type, etc.), and/or any other storage device or storage disk. The instructions of the non-transitory computer readable and/or machine-readable medium may program and/or be executed by programmable circuitry located in one or more hardware devices, but the entire program and/or parts thereof could alternatively be executed and/or instantiated by one or more hardware devices other than the programmable circuitry and/or embodied in dedicated hardware. The machine-readable instructions may be distributed across multiple hardware devices and/or executed by two or more hardware devices (e.g., a server and a client hardware device). For example, the client hardware device may be implemented by an endpoint client hardware device (e.g., a hardware device associated with a human and/or machine user) or an intermediate client hardware device gateway (e.g., a radio access network (RAN)) that may facilitate communication between a server and an endpoint client hardware device. Similarly, the non-transitory computer readable storage medium may include one or more mediums. Further, although the example program is described with reference to the flowchart(s) illustrated in FIGS. 12, 13, 14, and 15, many other methods of implementing the example transmitter control circuitry 116 of FIG. 3A, the example receiver control circuitry 120 of FIG. 3B, the example system 800 of FIG. 8, the example system 900 of FIG. 9, and/or the example system 1100 of FIG. 11 may alternatively be used. For example, the order of execution of the blocks of the flowchart(s) may be changed, and/or some of the blocks described may be changed, eliminated, or combined. Additionally or alternatively, any or all of the blocks of the flow chart may be implemented by one or more hardware circuits (e.g., processor circuitry, discrete and/or integrated analog and/or digital circuitry, an FPGA, an ASIC, a comparator, an operational-amplifier (op-amp), a logic circuit, etc.) structured to perform the corresponding operation without executing software or firmware. The programmable circuitry may be distributed in different network locations and/or local to one or more hardware devices (e.g., a single-core processor (e.g., a single core CPU), a multi-core processor (e.g., a multi-core CPU, an XPU, etc.)). For example, the programmable circuitry may be a CPU and/or an FPGA located in the same package (e.g., the same integrated circuit (IC) package or in two or more separate housings), one or more processors in a single machine, multiple processors distributed across multiple servers of a server rack, multiple processors distributed across one or more server racks, etc., and/or any combination(s) thereof.

The machine-readable instructions described herein may be stored in one or more of a compressed format, an encrypted format, a fragmented format, a compiled format, an executable format, a packaged format, etc. Machine readable instructions as described herein may be stored as data (e.g., computer-readable data, machine-readable data, one or more bits (e.g., one or more computer-readable bits, one or more machine-readable bits, etc.), a bitstream (e.g., a computer-readable bitstream, a machine-readable bitstream, etc.), etc.) or a data structure (e.g., as portion(s) of instructions, code, representations of code, etc.) that may be utilized to create, manufacture, and/or produce machine executable instructions. For example, the machine-readable instructions may be fragmented and stored on one or more storage devices, disks, and/or computing devices (e.g., servers) located at the same or different locations of a network or collection of networks (e.g., in the cloud, in edge devices, etc.). The machine-readable instructions may require one or more of installation, modification, adaptation, updating, combining, supplementing, configuring, decryption, decompression, unpacking, distribution, reassignment, compilation, etc., in order to make them directly readable, interpretable, and/or executable by a computing device and/or other machine. For example, the machine readable instructions may be stored in multiple parts, which are individually compressed, encrypted, and/or stored on separate computing devices, wherein the parts when decrypted, decompressed, and/or combined form a set of computer-executable and/or machine executable instructions that implement one or more functions and/or operations that may together form a program such as that described herein.

In another example, the machine readable instructions may be stored in a state in which they may be read by programmable circuitry, but require addition of a library (e.g., a dynamic link library (DLL)), a software development kit (SDK), an application programming interface (API), etc., in order to execute the machine-readable instructions on a particular computing device or other device. In another example, the machine-readable instructions may need to be configured (e.g., settings stored, data input, network addresses recorded, etc.) before the machine-readable instructions and/or the corresponding program(s) can be executed in whole or in part. Thus, machine readable, computer readable and/or machine-readable media, as used herein, may include instructions and/or program(s) regardless of the particular format or state of the machine-readable instructions and/or program(s).

The machine-readable instructions described herein can be represented by any past, present, or future instruction language, scripting language, programming language, etc. For example, the machine-readable instructions may be represented using any of the following languages: C, C++, Java, C#, Perl, Python, JavaScript, HyperText Markup Language (HTML), Structured Query Language (SQL), Swift, etc.

As mentioned above, the example operations of FIGS. 12, 13, 14, and/or 15 may be implemented using executable instructions (e.g., computer readable and/or machine-readable instructions) stored on one or more non-transitory computer readable and/or machine-readable media. As used herein, the terms non-transitory computer readable medium, non-transitory computer readable storage medium, non-transitory machine readable medium, and/or non-transitory machine-readable storage medium are expressly defined to include any type of computer readable storage device and/or storage disk and to exclude propagating signals and to exclude transmission media. Examples of such non-transitory computer readable medium, non-transitory computer readable storage medium, non-transitory machine readable medium, and/or non-transitory machine readable storage medium include optical storage devices, magnetic storage devices, an HDD, a flash memory, a read-only memory (ROM), a CD, a DVD, a cache, a RAM of any type, a register, and/or any other storage device or storage disk in which information is stored for any duration (e.g., for extended time periods, permanently, for brief instances, for temporarily buffering, and/or for caching of the information). As used herein, the terms "non-transitory computer readable storage device" and "non-transitory machine-readable storage device" are defined to include any physical (mechanical, magnetic, and/or electrical) hardware to retain information for a time period, but to exclude propagating signals and to exclude transmission media. Examples of non-transitory computer readable storage devices and/ or non-transitory machine-readable storage devices include random access memory of any type, read only memory of any type, solid state memory, flash memory, optical discs, magnetic disks, disk drives, and/or redundant array of independent disks (RAID) systems. As used herein, the term "device" refers to physical structure such as mechanical and/or electrical equipment, hardware, and/or circuitry that may or may not be configured by computer readable instructions, machine readable instructions, etc., and/or manufactured to execute computer-readable instructions, machine-readable instructions, etc.

FIG. 12 is a flowchart representative of example machine readable instructions and/or example operations 1200 that may be executed, instantiated, and/or performed by example programmable circuitry to implement the processor circuitry 802 of FIG. 8. The example machine-readable instructions and/or the example operations 1200 of FIG. 12 begin at block 1202, at which the processor circuitry 802 identifies a partition that is idle in a system in a package. At block 1204, the processor circuitry 802 programs transmitter control circuitry and receiver control circuitry to perform, over a threshold number of clock cycles, a test on communication channels of the partition. In the example of FIG. 12, the transmitter control circuitry and the receiver control circuitry are included in the partition.

In the illustrated example of FIG. 12, at block 1206, the processor circuitry 802 programs the transmitter control circuitry with first initial values for toggle patterns to be sent by transmitter circuitry over the communications channels. At block 1208, the processor circuitry 802 programs the receiver control circuitry with second initial values for receiver circuitry. In the example of FIG. 12, the transmitter circuitry and the receiver circuitry are included in the partition. As described herein, the transmitter control circuitry injects test data for specific number (e.g., threshold number) of clock cycles using a test input and the receiver control circuitry receives the test data and sets one or more output flip-flops if a defect is detected. In the example of FIG. 12, at block 1210, the processor circuitry 802 reads at least one debug register set by the receiver control circuitry.

In the illustrated example of FIG. 12, at block 1212, the processor circuitry 802 determines whether at least one error was detected in at least one communication channel of the partition. For example, the processor circuitry 802 determines whether an error was detected based on a value of the at least one debug register. Based on (e.g., in response to) the processor circuitry 802 determining that at least one error was detected (block 1212: YES), the machine-readable instructions and/or the operations 1200 proceed to block 1214. Based on (e.g., in response to) the processor circuitry 802 determining that at least one error was not detected (block 1212: NO), the machine-readable instructions and/or the operations 1200 proceed to block 1216.

In the illustrated example of FIG. 12, at block 1214, the processor circuitry 802 sets at least one repair register corresponding to the at least one communication channel in which the at least one error was detected. At block 1216, the processor circuitry determines whether there is an additional partition to test. Based on (e.g., in response to) the processor circuitry 802 determining that there is an additional partition to test (block 1216: YES), the machine-readable instructions and/or the operations 1200 return to block 1202. Based on (e.g., in response to) the processor circuitry 802 determining that there is not an additional partition to test (block 1216: NO), the machine-readable instructions and/or the operations 1200 terminate.

FIG. 13 is a flowchart representative of example machine readable instructions and/or example operations 1300 that may be executed, instantiated, and/or performed by example programmable circuitry to implement the transmitter control circuitry 116 of FIG. 3A. The example machine-readable instructions and/or the example operations 1300 of FIG. 13 begin at block 1302, at which the test control circuitry 302 selects a first communication channel to test (e.g., as identified by the one or more victim identity registers of the configuration register space 308). In the example of FIG. 13, the selected communication channel corresponds to a first transmit circuit.

In the illustrated example of FIG. 13, at block 1304, the test control circuitry 302 initializes a first functional flip-flop of the first transmit circuit and a first testing flip-flop of the first transmit circuit to a first value. For example, the first functional flip-flop and the first testing flip-flop are to operate at a first frequency. In the example of FIG. 13, the first frequency corresponds to the first frequency of the first clock of the first transmit circuit (e.g., which is less than the second frequency of the second clock of the first transmit circuit).

In the illustrated example of FIG. 13, at block 1306, the test control circuitry 302 initializes respective second functional flip-flops of second transmit circuits and respective second testing flip-flops of the second transmit circuits to a second value. For example, the respective second functional flip-flops and the respective testing flip-flops are to operate at the first frequency. In the example of FIG. 13, the first frequency corresponds to the first frequency of respective first clocks of the second transmit circuits (e.g., which is less than the second frequency of respective second clocks of the second transmit circuits). Additionally, the test control circuitry 302 initializes the first functional flip-flop, the first testing flip-flop, the respective second functional flip-flops, and the respective second testing flip-flops based on the initial values register of the configuration register space 308.

In the illustrated example of FIG. 13, at block 1308, the clock control circuitry 304 disables respective first clocks having the first frequency and respective second clocks having the second frequency. Additionally, at block 1310, the clock control circuitry 304 causes the first functional flip-flop, the first testing flip-flop, the respective second functional flip-flops, and the respective second testing flip-flops to operate at the second frequency. As described above, in the example of FIG. 13, the second frequency is greater than the first frequency.

In the illustrated example of FIG. 13, at block 1312, the clock control circuitry 304 enables the respective second clocks of the first transmit circuit and the second transmit circuits. At block 1314, the LFSR 306 generates test data to cause (1) the first transmit circuit to send a first toggle pattern to a first receive circuit over the selected communication channel and (2) the second transmit circuits to send a second toggle pattern to second receive circuits over second communication channels. As described above, the first toggle pattern and the second toggle pattern can be similar to the patterns discussed in connection with FIGS. 2A-2F in relation to victim and aggressor lines. After the threshold number of clock cycles, the clock control circuitry 304 disables the respective first clocks and the respective second clocks at block 1316.

In the illustrated example of FIG. 13, at block 1318, the clock control circuitry 304 causes the first functional flip-flop, the first testing flip-flop, the respective second functional flip-flops, and the respective second testing flip-flops to operate at the first frequency. As described above, in the example of FIG. 13, the first frequency is less than the second frequency. In the example of FIG. 13, at block 1320, the test control circuitry 302 determines whether there is an additional communication channel to test. Based on (e.g., in response to) the test control circuitry 302 determining that there is an additional communication channel to test (block 1320: YES), the machine-readable instructions and/or the operations 1300 proceed to block 1322 where the test control circuitry 302 selects a next communication channel to test. Based on (e.g., in response to) the test control circuitry 302 determining that there is not an additional communication channel to test (block 1320: NO), the machine-readable instructions and/or the operations 1300 terminate.

FIG. 14 is a flowchart representative of example machine readable instructions and/or example operations 1400 that may be executed, instantiated, and/or performed by example programmable circuitry to implement the receiver control circuitry 120 of FIG. 3B. The example machine-readable instructions and/or the example operations 1400 of FIG. 14 begin at block 1402, at which the test control circuitry 312 selects a first communication channel to monitor (e.g., as identified by the one or more victim identity registers of the configuration register space 318). In the example of FIG. 14, the selected communication channel corresponds to a first receive circuit.

In the illustrated example of FIG. 14, at block 1404, the test control circuitry 312 initializes a first functional flip-flop of the first receive circuit and a first testing flip-flop of the first receive circuit to a first value. For example, the first functional flip-flop and the first testing flip-flop are to operate at a first frequency. In the example of FIG. 14, the first frequency corresponds to the first frequency of the first clock of the first transmit circuit (e.g., which is less than the second frequency of the second clock of the first receive circuit).

In the illustrated example of FIG. 14, at block 1406, the test control circuitry 312 initializes respective second functional flip-flops of second receive circuits and respective second testing flip-flops of the second receive circuits to a second value. For example, the respective second functional flip-flops and the respective testing flip-flops are to operate at the first frequency. In the example of FIG. 13, the first frequency corresponds to the first frequency of respective first clocks of the second receive circuits (e.g., which is less than the second frequency of respective second clocks of the second receive circuits). Additionally, the test control circuitry 312 initializes the first functional flip-flop, the first testing flip-flop, the respective second functional flip-flops, and the respective second testing flip-flops based on the initial values register of the configuration register space 318.

In the illustrated example of FIG. 14, at block 1408, the clock control circuitry 314 disables respective first clocks having the first frequency and respective second clocks having the second frequency. Additionally, at block 1410, the clock control circuitry 314 causes the first functional flip-flop, the first testing flip-flop, the respective second functional flip-flops, and the respective second testing flip-flops to operate at the second frequency. As described above, in the example of FIG. 14, the second frequency is greater than the first frequency.

In the illustrated example of FIG. 14, at block 1412, the clock control circuitry 314 enables the respective second clocks of the first receive circuit and the second receive circuits. At block 1414, the MISR 316 collects test data from the first receive circuit and the second receive circuits. For example, the first receive circuit is to receive a first toggle pattern from a first transmit circuit over the selected communication channel. Additionally, for example, the second receive circuits are to receive a second toggle pattern from second transmit circuits over second communication channels. As described above, the first toggle pattern and the second toggle pattern can be similar to the patterns discussed in connection with FIGS. 2A-2F in relation to victim and aggressor lines. After the threshold number of clock cycles, the clock control circuitry 314 disables the respective first clocks and the respective second clocks at block 1416.

In the illustrated example of FIG. 14, at block 1418, the clock control circuitry 314 causes the first functional flip-flop, the first testing flip-flop, the respective second functional flip-flops, and the respective second testing flip-flops. As described above, in the example of FIG. 14, the first frequency is less than the second frequency. In the example of FIG. 14, at block 1420, the testing control circuitry 312 reads a register corresponding to respective output flip-flops of the first receive circuit and the second receive circuits to determine if an error is present in any of the first communication channel or the second communication channels.

In the illustrated example of FIG. 14, at block 1422, the test control circuitry 312 determines whether there is an additional communication channel to test. Based on (e.g., in response to) the test control circuitry 312 determining that there is an additional communication channel to test (block 1422: YES), the machine-readable instructions and/or the operations 1400 proceed to block 1424. At block 1424, the test control circuitry 312 selects a next communication channel to monitor. Based on (e.g., in response to) the test control circuitry 312 determining that there is not an additional communication channel to test (block 1422: NO), the machine-readable instructions and/or the operations 1400 proceed to block 1426. At block 1426, the test control circuitry 312 sets at least one debug register based on whether at least one error was detected.

FIG. 15 is a flowchart representative of example machine readable instructions and/or example operations 1500 that may be executed, instantiated, and/or performed by example programmable circuitry to implement the system 1100 of FIG. 11. The example machine-readable instructions and/or the example operations 1500 of FIG. 15 begin at block 1502, at which the processor circuitry 1108 sets a first threshold margin for a first sensor associated with a first communication channel that is to conduct a signal. For example, the first communication channel is included in a partition of a system in a package (SiP).

In the illustrated example of FIG. 15, at block 1504, the sensor circuitry 1120 monitors the first communication channel. At block 1506, the sensor circuitry 1120 determines whether the first threshold margin has been satisfied. Based on (e.g., in response to) the sensor circuitry 1120 determining that the threshold margin has not been satisfied (block 1506: NO), the machine-readable instructions and/or the operations 1500 return to block 1504. Based on (e.g., in response to) the sensor circuitry 1120 determining that the threshold margin has been satisfied (block 1506: YES), the machine-readable instructions and/or the operations 1500 proceed to block 1508.

In the illustrated example of FIG. 15, at block 1508, the sensor circuitry 1120 sends an interrupt to processor circuitry associated with the SiP. For example, the sensor circuitry 1120 sends an interrupt to the processor circuitry 1108. At block 1510, based on the interrupt, the processor circuitry 1108 sets a repair register corresponding to the first communication channel. For example, the processor circuitry 1108 sets, via the protocol converter circuitry 1110 and the interface circuitry 1112, the one or more repair registers 1116.

In the illustrated example of FIG. 15, at block 1512, based on a value of the repair register, the decoder circuitry 1118 adjusts first multiplexers of transmitter circuitry and second multiplexers of receiver circuitry to avoid transmitting signals over the first communication channel. For example, the transmitter circuitry and the receiver circuitry are included in the partition. At block 1514, the processor circuitry 1108 sets a second threshold margin for a second sensor associated with a second communication channel that is to conduct the signal. For example, the processor circuitry 1108 sets the second threshold margin for a second sensor of the sensor circuitry 1120. In the example of FIG. 15, the second communication channel is included in the partition.

FIG. 16 is a block diagram of an example programmable circuitry platform 1600 structured to execute and/or instantiate the example machine-readable instructions and/or the example operations of FIGS. 12, 13, 14, and/or 15 to implement the example transmitter control circuitry 116 of FIG. 3A, the example receiver control circuitry 120 of FIG. 3B, the example system 800 of FIG. 8, the example system 900 of FIG. 9, and/or the example system 1100 of FIG. 11. The programmable circuitry platform 1600 can be, for example, a server, a personal computer, a workstation, a self-learning machine (e.g., a neural network), a mobile device (e.g., a cell phone, a smart phone, a tablet such as an iPad^{™}), a personal digital assistant (PDA), an Internet appliance, a DVD player, a CD player, a digital video recorder, a Blu-ray player, a gaming console, a personal video recorder, a set top box, a headset (e.g., an augmented reality (AR) headset, a virtual reality (VR) headset, etc.) or other wearable device, or any other type of computing and/or electronic device.

The programmable circuitry platform 1600 of the illustrated example includes programmable circuitry 1612. The programmable circuitry 1612 of the illustrated example is hardware. For example, the programmable circuitry 1612 can be implemented by one or more integrated circuits, logic circuits, FPGAs, microprocessors, CPUs, GPUs, DSPs, and/or microcontrollers from any desired family or manufacturer. The programmable circuitry 1612 may be implemented by one or more semiconductor based (e.g., silicon based) devices. In this example, the programmable circuitry 1612 implements the example processor circuitry 802, the example protocol converter circuitry 804, the example interface circuitry 806, the one or more example TAPs 808, the example processor circuitry 1108, the example protocol converter circuitry 1110, the example interface circuitry 1112, and the one or more examples TAPs 1114.

The programmable circuitry 1612 of the illustrated example includes a local memory 1613 (e.g., a cache, registers, etc.). The programmable circuitry 1612 of the illustrated example is in communication with main memory 1614, 1616, which includes a volatile memory 1614 and a non-volatile memory 1616, by a bus 1618. The volatile memory 1614 may be implemented by Synchronous Dynamic Random Access Memory (SDRAM), Dynamic Random Access Memory (DRAM), RAMBUS^{®} Dynamic Random Access Memory (RDRAM^{®}), and/or any other type of RAM device. The non-volatile memory 1616 may be implemented by flash memory and/or any other desired type of memory device. Access to the main memory 1614, 1616 of the illustrated example is controlled by a memory controller 1617. In some examples, the memory controller 1617 may be implemented by one or more integrated circuits, logic circuits, microcontrollers from any desired family or manufacturer, or any other type of circuitry to manage the flow of data going to and from the main memory 1614, 1616.

The programmable circuitry platform 1600 of the illustrated example also includes interface circuitry 1620. The interface circuitry 1620 may be implemented by hardware in accordance with any type of interface standard, such as an Ethernet interface, a universal serial bus (USB) interface, a Bluetooth^{®} interface, a near field communication (NFC) interface, a Peripheral Component Interconnect (PCI) interface, and/or a Peripheral Component Interconnect Express (PCIe) interface.

In the illustrated example, one or more input devices 1622 are connected to the interface circuitry 1620. The input device(s) 1622 permit(s) a user (e.g., a human user, a machine user, etc.) to enter data and/or commands into the programmable circuitry 1612. The input device(s) 1622 can be implemented by, for example, an audio sensor, a microphone, a camera (still or video), a keyboard, a button, a mouse, a touchscreen, a trackpad, a trackball, an isopoint device, and/or a voice recognition system.

One or more output devices 1624 are also connected to the interface circuitry 1620 of the illustrated example. The output device(s) 1624 can be implemented, for example, by display devices (e.g., a light emitting diode (LED), an organic light emitting diode (OLED), a liquid crystal display (LCD), a cathode ray tube (CRT) display, an in-place switching (IPS) display, a touchscreen, etc.), a tactile output device, a printer, and/or speaker. The interface circuitry 1620 of the illustrated example, thus, typically includes a graphics driver card, a graphics driver chip, and/or graphics processor circuitry such as a GPU.

The interface circuitry 1620 of the illustrated example also includes a communication device such as a transmitter, a receiver, a transceiver, a modem, a residential gateway, a wireless access point, and/or a network interface to facilitate exchange of data with external machines (e.g., computing devices of any kind) by a network 1626. The communication can be by, for example, an Ethernet connection, a digital subscriber line (DSL) connection, a telephone line connection, a coaxial cable system, a satellite system, a beyond-line-of-sight wireless system, a line-of-sight wireless system, a cellular telephone system, an optical connection, etc. In this example, the interface circuitry 1620 implements the example test control circuitry 302, the example clock control circuitry 304, the example LFSR 306, the example configuration register space 308, the example test control circuitry 312, the example clock control circuitry 314, the example MISR 316, the example configuration register space 318, the one or more example repair registers 902, the decoder circuitry 904, the first example die 1104, the second example die 1106, the one or more example repair registers 1116, the example decoder circuitry 1118, the example sensor circuitry 1120, the example transmitter circuitry 1122, the example transmitter control circuitry 1124, the example receiver circuitry 1126, and the example receiver control circuitry 1128.

The programmable circuitry platform 1600 of the illustrated example also includes one or more mass storage discs or devices 1628 to store firmware, software, and/or data. Examples of such mass storage discs or devices 1628 include magnetic storage devices (e.g., floppy disk, drives, HDDs, etc.), optical storage devices (e.g., Blu-ray disks, CDs, DVDs, etc.), RAID systems, and/or solid-state storage discs or devices such as flash memory devices and/or SSDs.

The machine readable instructions 1632, which may be implemented by the machine readable instructions of FIGS. 12, 13, 14, and/or 15, may be stored in the mass storage device 1628, in the volatile memory 1614, in the non-volatile memory 1616, and/or on at least one non-transitory computer readable storage medium such as a CD or DVD which may be removable.

FIG. 17 is a block diagram of an example implementation of the programmable circuitry 1612 of FIG. 16. In this example, the programmable circuitry 1612 of FIG. 16 is implemented by a microprocessor 1700. For example, the microprocessor 1700 may be a general-purpose microprocessor (e.g., general-purpose microprocessor circuitry). The microprocessor 1700 executes some or all of the machine-readable instructions of the flowcharts of FIGS. 12, 13, 14, and/or 15 to effectively instantiate the circuitry of FIGS. 3A, 3B, 8, 9, and/or 11 as logic circuits to perform operations corresponding to those machine-readable instructions. In some such examples, the circuitry of FIGS. 3A, 3B, 8, 9, and/or 11 is instantiated by the hardware circuits of the microprocessor 1700 in combination with the machine-readable instructions. For example, the microprocessor 1700 may be implemented by multi-core hardware circuitry such as a CPU, a DSP, a GPU, an XPU, etc. Although it may include any number of example cores 1702 (e.g., 1 core), the microprocessor 1700 of this example is a multi-core semiconductor device including N cores. The cores 1702 of the microprocessor 1700 may operate independently or may cooperate to execute machine readable instructions. For example, machine code corresponding to a firmware program, an embedded software program, or a software program may be executed by one of the cores 1702 or may be executed by multiple ones of the cores 1702 at the same or different times. In some examples, the machine code corresponding to the firmware program, the embedded software program, or the software program is split into threads and executed in parallel by two or more of the cores 1702. The software program may correspond to a portion or all of the machine-readable instructions and/or operations represented by the flowcharts of FIGS. 12, 13, 14, and/or 15.

The cores 1702 may communicate by a first example bus 1704. In some examples, the first bus 1704 may be implemented by a communication bus to effectuate communication associated with one(s) of the cores 1702. For example, the first bus 1704 may be implemented by at least one of an Inter-Integrated Circuit (I2C) bus, a Serial Peripheral Interface (SPI) bus, a PCI bus, or a PCIe bus. Additionally or alternatively, the first bus 1704 may be implemented by any other type of computing or electrical bus. The cores 1702 may obtain data, instructions, and/or signals from one or more external devices by example interface circuitry 1706. The cores 1702 may output data, instructions, and/or signals to the one or more external devices by the interface circuitry 1706. Although the cores 1702 of this example include example local memory 1720 (e.g., Level 1 (L1) cache that may be split into an L1 data cache and an L1 instruction cache), the microprocessor 1700 also includes example shared memory 1710 that may be shared by the cores (e.g., Level 2 (L2 cache)) for high-speed access to data and/or instructions. Data and/or instructions may be transferred (e.g., shared) by writing to and/or reading from the shared memory 1710. The local memory 1720 of each of the cores 1702 and the shared memory 1710 may be part of a hierarchy of storage devices including multiple levels of cache memory and the main memory (e.g., the main memory 1614, 1616 of FIG. 16). Typically, higher levels of memory in the hierarchy exhibit lower access time and have smaller storage capacity than lower levels of memory. Changes in the various levels of the cache hierarchy are managed (e.g., coordinated) by a cache coherency policy.

Each core 1702 may be referred to as a CPU, DSP, GPU, etc., or any other type of hardware circuitry. Each core 1702 includes control unit circuitry 1714, arithmetic and logic (AL) circuitry 1716 (sometimes referred to as an ALU), a plurality of registers 1718, the local memory 1720, and a second example bus 1722. Other structures may be present. For example, each core 1702 may include vector unit circuitry, single instruction multiple data (SIMD) unit circuitry, load/store unit (LSU) circuitry, branch/jump unit circuitry, floating-point unit (FPU) circuitry, etc. The control unit circuitry 1714 includes semiconductor-based circuits structured to control (e.g., coordinate) data movement within the corresponding core 1702. The AL circuitry 1716 includes semiconductor-based circuits structured to perform one or more mathematic and/or logic operations on the data within the corresponding core 1702. The AL circuitry 1716 of some examples performs integer-based operations. In other examples, the AL circuitry 1716 also performs floating-point operations. In yet other examples, the AL circuitry 1716 may include first AL circuitry that performs integer-based operations and second AL circuitry that performs floating-point operations. In some examples, the AL circuitry 1716 may be referred to as an Arithmetic Logic Unit (ALU).

The registers 1718 are semiconductor-based structures to store data and/or instructions such as results of one or more of the operations performed by the AL circuitry 1716 of the corresponding core 1702. For example, the registers 1718 may include vector register(s), SIMD register(s), general-purpose register(s), flag register(s), segment register(s), machine-specific register(s), instruction pointer register(s), control register(s), debug register(s), memory management register(s), machine check register(s), etc. The registers 1718 may be arranged in a bank as shown in FIG. 17. Alternatively, the registers 1718 may be organized in any other arrangement, format, or structure, such as by being distributed throughout the core 1702 to shorten access time. The second bus 1722 may be implemented by at least one of an I2C bus, a SPI bus, a PCI bus, or a PCIe bus.

Each core 1702 and/or, more generally, the microprocessor 1700 may include additional and/or alternate structures to those shown and described above. For example, one or more clock circuits, one or more power supplies, one or more power gates, one or more cache home agents (CHAs), one or more converged/common mesh stops (CMSs), one or more shifters (e.g., barrel shifter(s)) and/or other circuitry may be present. The microprocessor 1700 is a semiconductor device fabricated to include many transistors interconnected to implement the structures described above in one or more integrated circuits (ICs) contained in one or more packages.

The microprocessor 1700 may include and/or cooperate with one or more accelerators (e.g., acceleration circuitry, hardware accelerators, etc.). In some examples, accelerators are implemented by logic circuitry to perform certain tasks more quickly and/or efficiently than can be done by a general-purpose processor. Examples of accelerators include ASICs and FPGAs such as those discussed herein. A GPU, DSP and/or other programmable device can also be an accelerator. Accelerators may be on-board the microprocessor 1700, in the same chip package as the microprocessor 1700 and/or in one or more separate packages from the microprocessor 1700.

FIG. 18 is a block diagram of another example implementation of the programmable circuitry 1612 of FIG. 16. In this example, the programmable circuitry 1612 is implemented by FPGA circuitry 1800. For example, the FPGA circuitry 1800 may be implemented by an FPGA. The FPGA circuitry 1800 can be used, for example, to perform operations that could otherwise be performed by the example microprocessor 1700 of FIG. 17 executing corresponding machine-readable instructions. However, once configured, the FPGA circuitry 1800 instantiates the operations and/or functions corresponding to the machine-readable instructions in hardware and, thus, can often execute the operations/functions faster than they could be performed by a general-purpose microprocessor executing the corresponding software.

More specifically, in contrast to the microprocessor 1700 of FIG. 17 described above (which is a general purpose device that may be programmed to execute some or all of the machine readable instructions represented by the flowchart(s) of FIGS. 12, 13, 14, and/or 15 but whose interconnections and logic circuitry are fixed once fabricated), the FPGA circuitry 1800 of the example of FIG. 18 includes interconnections and logic circuitry that may be configured, structured, programmed, and/or interconnected in different ways after fabrication to instantiate, for example, some or all of the operations/functions corresponding to the machine readable instructions represented by the flowchart(s) of FIGS. 12, 13, 14, and/or 15. In particular, the FPGA circuitry 1800 may be thought of as an array of logic gates, interconnections, and switches. The switches can be programmed to change how the logic gates are interconnected by the interconnections, effectively forming one or more dedicated logic circuits (unless and until the FPGA circuitry 1800 is reprogrammed). The configured logic circuits enable the logic gates to cooperate in different ways to perform different operations on data received by input circuitry. Those operations may correspond to some or all of the instructions (e.g., the software and/or firmware) represented by the flowchart(s) of FIGS. 12, 13, 14, and/or 15. As such, the FPGA circuitry 1800 may be configured and/or structured to effectively instantiate some or all of the operations/functions corresponding to the machine readable instructions of the flowchart(s) of FIGS. 12, 13, 14, and/or 15 as dedicated logic circuits to perform the operations/functions corresponding to those software instructions in a dedicated manner analogous to an ASIC. Therefore, the FPGA circuitry 1800 may perform the operations/functions corresponding to the some or all of the machine-readable instructions of FIGS. 12, 13, 14, and/or 15 faster than the general-purpose microprocessor can execute the same.

In the example of FIG. 18, the FPGA circuitry 1800 is configured and/or structured in response to being programmed (and/or reprogrammed one or more times) based on a binary file. In some examples, the binary file may be compiled and/or generated based on instructions in a hardware description language (HDL) such as Lucid, Very High Speed Integrated Circuits (VHSIC) Hardware Description Language (VHDL), or Verilog. For example, a user (e.g., a human user, a machine user, etc.) may write code or a program corresponding to one or more operations/functions in an HDL; the code/program may be translated into a low-level language as needed; and the code/program (e.g., the code/program in the low-level language) may be converted (e.g., by a compiler, a software application, etc.) into the binary file. In some examples, the FPGA circuitry 1800 of FIG. 18 may access and/or load the binary file to cause the FPGA circuitry 1800 of FIG. 18 to be configured and/or structured to perform the one or more operations/functions. For example, the binary file may be implemented by a bit stream (e.g., one or more computer-readable bits, one or more machine-readable bits, etc.), data (e.g., computer-readable data, machine-readable data, etc.), and/or machine-readable instructions accessible to the FPGA circuitry 1800 of FIG. 18 to cause configuration and/or structuring of the FPGA circuitry 1800 of FIG. 18, or portion(s) thereof.

In some examples, the binary file is compiled, generated, transformed, and/or otherwise output from a uniform software platform utilized to program FPGAs. For example, the uniform software platform may translate first instructions (e.g., code or a program) that correspond to one or more operations/functions in a high-level language (e.g., C, C++, Python, etc.) into second instructions that correspond to the one or more operations/functions in an HDL. In some such examples, the binary file is compiled, generated, and/or otherwise output from the uniform software platform based on the second instructions. In some examples, the FPGA circuitry 1800 of FIG. 18 may access and/or load the binary file to cause the FPGA circuitry 1800 of FIG. 18 to be configured and/or structured to perform the one or more operations/functions. For example, the binary file may be implemented by a bit stream (e.g., one or more computer-readable bits, one or more machine-readable bits, etc.), data (e.g., computer-readable data, machine-readable data, etc.), and/or machine-readable instructions accessible to the FPGA circuitry 1800 of FIG. 18 to cause configuration and/or structuring of the FPGA circuitry 1800 of FIG. 18, or portion(s) thereof.

The FPGA circuitry 1800 of FIG. 18, includes example input/output (I/O) circuitry 1802 to obtain and/or output data to/from example configuration circuitry 1804 and/or external hardware 1806. For example, the configuration circuitry 1804 may be implemented by interface circuitry that may obtain a binary file, which may be implemented by a bit stream, data, and/or machine-readable instructions, to configure the FPGA circuitry 1800, or portion(s) thereof. In some such examples, the configuration circuitry 1804 may obtain the binary file from a user, a machine (e.g., hardware circuitry (e.g., programmable or dedicated circuitry) that may implement an Artificial Intelligence/Machine Learning (AI/ML) model to generate the binary file), etc., and/or any combination(s) thereof). In some examples, the external hardware 1806 may be implemented by external hardware circuitry. For example, the external hardware 1806 may be implemented by the microprocessor 1700 of FIG. 17.

The FPGA circuitry 1800 also includes an array of example logic gate circuitry 1808, a plurality of example configurable interconnections 1810, and example storage circuitry 1812. The logic gate circuitry 1808 and the configurable interconnections 1810 are configurable to instantiate one or more operations/functions that may correspond to at least some of the machine-readable instructions of FIGS. 12, 13, 14, and/or 15 and/or other desired operations. The logic gate circuitry 1808 shown in FIG. 18 is fabricated in blocks or groups. Each block includes semiconductor-based electrical structures that may be configured into logic circuits. In some examples, the electrical structures include logic gates (e.g., And gates, Or gates, Nor gates, etc.) that provide basic building blocks for logic circuits. Electrically controllable switches (e.g., transistors) are present within each of the logic gate circuitry 1808 to enable configuration of the electrical structures and/or the logic gates to form circuits to perform desired operations/functions. The logic gate circuitry 1808 may include other electrical structures such as look-up tables (LUTs), registers (e.g., flip-flops or latches), multiplexers, etc.

The configurable interconnections 1810 of the illustrated example are conductive pathways, traces, vias, or the like that may include electrically controllable switches (e.g., transistors) whose state can be changed by programming (e.g., using an HDL instruction language) to activate or deactivate one or more connections between one or more of the logic gate circuitry 1808 to program desired logic circuits.

The storage circuitry 1812 of the illustrated example is structured to store result(s) of the one or more of the operations performed by corresponding logic gates. The storage circuitry 1812 may be implemented by registers or the like. In the illustrated example, the storage circuitry 1812 is distributed amongst the logic gate circuitry 1808 to facilitate access and increase execution speed.

The example FPGA circuitry 1800 of FIG. 18 also includes example dedicated operations circuitry 1814. In this example, the dedicated operations circuitry 1814 includes special purpose circuitry 1816 that may be invoked to implement commonly used functions to avoid the need to program those functions in the field. Examples of such special purpose circuitry 1816 include memory (e.g., DRAM) controller circuitry, PCIe controller circuitry, clock circuitry, transceiver circuitry, memory, and multiplier-accumulator circuitry. Other types of special purpose circuitry may be present. In some examples, the FPGA circuitry 1800 may also include example general purpose programmable circuitry 1818 such as an example CPU 1820 and/or an example DSP 1822. Other general purpose programmable circuitry 1818 may additionally or alternatively be present such as a GPU, an XPU, etc., that can be programmed to perform other operations.

Although FIGS. 17 and 18 illustrate two example implementations of the programmable circuitry 1612 of FIG. 16, many other approaches are contemplated. For example, FPGA circuitry may include an on-board CPU, such as one or more of the example CPU 1820 of FIG. 17. Therefore, the programmable circuitry 1612 of FIG. 16 may additionally be implemented by combining at least the example microprocessor 1700 of FIG. 17 and the example FPGA circuitry 1800 of FIG. 18. In some such hybrid examples, one or more cores 1702 of FIG. 17 may execute a first portion of the machine readable instructions represented by the flowchart(s) of FIGS. 12, 13, 14, and/or 15 to perform first operation(s)/function(s), the FPGA circuitry 1800 of FIG. 18 may be configured and/or structured to perform second operation(s)/function(s) corresponding to a second portion of the machine readable instructions represented by the flowcharts of FIGS. 12, 13, 14, and/or 15, and/or an ASIC may be configured and/or structured to perform third operation(s)/function(s) corresponding to a third portion of the machine readable instructions represented by the flowcharts of FIGS. 12, 13, 14, and/or 15.

It should be understood that some or all of the circuitry of FIGS. 3A, 3B, 8, 9, and/or 11 may, thus, be instantiated at the same or different times. For example, same and/or different portion(s) of the microprocessor 1700 of FIG. 17 may be programmed to execute portion(s) of machine-readable instructions at the same and/or different times. In some examples, same and/or different portion(s) of the FPGA circuitry 1800 of FIG. 18 may be configured and/or structured to perform operations/functions corresponding to portion(s) of machine-readable instructions at the same and/or different times.

In some examples, some or all of the circuitry of FIGS. 3A, 3B, 8, 9, and/or 11 may be instantiated, for example, in one or more threads executing concurrently and/or in series. For example, the microprocessor 1700 of FIG. 17 may execute machine readable instructions in one or more threads executing concurrently and/or in series. In some examples, the FPGA circuitry 1800 of FIG. 18 may be configured and/or structured to carry out operations/functions concurrently and/or in series. Moreover, in some examples, some or all of the circuitry of FIGS. 3A, 3B, 8, 9, and/or 11 may be implemented within one or more virtual machines and/or containers executing on the microprocessor 1700 of FIG. 17.

In some examples, the programmable circuitry 1612 of FIG. 16 may be in one or more packages. For example, the microprocessor 1700 of FIG. 17 and/or the FPGA circuitry 1800 of FIG. 18 may be in one or more packages. In some examples, an XPU may be implemented by the programmable circuitry 1612 of FIG. 16, which may be in one or more packages. For example, the XPU may include a CPU (e.g., the microprocessor 1700 of FIG. 17, the CPU 1820 of FIG. 18, etc.) in one package, a DSP (e.g., the DSP 1822 of FIG. 18) in another package, a GPU in yet another package, and an FPGA (e.g., the FPGA circuitry 1800 of FIG. 18) in still yet another package.

A block diagram illustrating an example software distribution platform 1905 to distribute software such as the example machine readable instructions 1632 of FIG. 16 to other hardware devices (e.g., hardware devices owned and/or operated by third parties from the owner and/or operator of the software distribution platform) is illustrated in FIG. 19. The example software distribution platform 1905 may be implemented by any computer server, data facility, cloud service, etc., capable of storing and transmitting software to other computing devices. The third parties may be customers of the entity owning and/or operating the software distribution platform 1905. For example, the entity that owns and/or operates the software distribution platform 1905 may be a developer, a seller, and/or a licensor of software such as the example machine readable instructions 1632 of FIG. 16. The third parties may be consumers, users, retailers, OEMs, etc., who purchase and/or license the software for use and/or re-sale and/or sub-licensing. In the illustrated example, the software distribution platform 1905 includes one or more servers and one or more storage devices. The storage devices store the machine-readable instructions 1632, which may correspond to the example machine readable instructions of FIGS. 12, 13, 14, and/or 15, as described above. The one or more servers of the example software distribution platform 1905 are in communication with an example network 1910, which may correspond to any one or more of the Internet and/or any of the example networks described above. In some examples, the one or more servers are responsive to requests to transmit the software to a requesting party as part of a commercial transaction. Payment for the delivery, sale, and/or license of the software may be handled by the one or more servers of the software distribution platform and/or by a third-party payment entity. The servers enable purchasers and/or licensors to download the machine-readable instructions 1632 from the software distribution platform 1905. For example, the software, which may correspond to the example machine readable instructions of FIG. 12, 13, 14, and/or 15, may be downloaded to the example programmable circuitry platform 1600, which is to execute the machine readable instructions 1632 to implement the example transmitter control circuitry 116 of FIG. 3A, the example receiver control circuitry 120 of FIG. 3B, the example system 800 of FIG. 8, the example system 900 of FIG. 9, and/or the example system 1100 of FIG. 11. In some examples, one or more servers of the software distribution platform 1905 periodically offer, transmit, and/or force updates to the software (e.g., the example machine readable instructions 1632 of FIG. 16) to ensure improvements, patches, updates, etc., are distributed and applied to the software at the end user devices. Although referred to as software above, the distributed "software" could alternatively be firmware.

"Including" and "comprising" (and all forms and tenses thereof) are used herein to be open ended terms. Thus, whenever a claim employs any form of "include" or "comprise" (e.g., comprises, includes, comprising, including, having, etc.) as a preamble or within a claim recitation of any kind, it is to be understood that additional elements, terms, etc., may be present without falling outside the scope of the corresponding claim or recitation. As used herein, when the phrase "at least" is used as the transition term in, for example, a preamble of a claim, it is open-ended in the same manner as the term "comprising" and "including" are open ended. The term "and/or" when used, for example, in a form such as A, B, and/or C refers to any combination or subset of A, B, C such as (1) A alone, (2) B alone, (3) C alone, (4) A with B, (5) A with C, (6) B with C, or (7) A with B and with C. As used herein in the context of describing structures, components, items, objects and/or things, the phrase "at least one of A and B" is intended to refer to implementations including any of (1) at least one A, (2) at least one B, or (3) at least one A and at least one B. Similarly, as used herein in the context of describing structures, components, items, objects and/or things, the phrase "at least one of A or B" is intended to refer to implementations including any of (1) at least one A, (2) at least one B, or (3) at least one A and at least one B. As used herein in the context of describing the performance or execution of processes, instructions, actions, activities, etc., the phrase "at least one of A and B" is intended to refer to implementations including any of (1) at least one A, (2) at least one B, or (3) at least one A and at least one B. Similarly, as used herein in the context of describing the performance or execution of processes, instructions, actions, activities, etc., the phrase "at least one of A or B" is intended to refer to implementations including any of (1) at least one A, (2) at least one B, or (3) at least one A and at least one B.

As used herein, singular references (e.g., "a," "an," "first," "second," etc.) do not exclude a plurality. The term "a" or "an" object, as used herein, refers to one or more of that object. The terms "a" (or "an"), "one or more," and "at least one" are used interchangeably herein. Furthermore, although individually listed, a plurality of means, elements, or actions may be implemented by, e.g., the same entity or object. Additionally, although individual features may be included in different examples or claims, these may be combined, and the inclusion in different examples or claims does not imply that a combination of features is not feasible and/or advantageous.

As used herein, unless otherwise stated, the term "above" describes the relationship of two parts relative to Earth. A first part is above a second part, if the second part has at least one part between Earth and the first part. Likewise, as used herein, a first part is "below" a second part when the first part is closer to the Earth than the second part. As noted above, a first part can be above or below a second part with one or more of: other parts therebetween, without other parts therebetween, with the first and second parts touching, or without the first and second parts being in direct contact with one another.

Notwithstanding the foregoing, in the case of referencing a semiconductor device (e.g., a transistor), a semiconductor die containing a semiconductor device, and/or an integrated circuit (IC) package containing a semiconductor die during fabrication or manufacturing, "above" is not with reference to Earth, but instead is with reference to an underlying substrate on which relevant components are fabricated, assembled, mounted, supported, or otherwise provided. Thus, as used herein and unless otherwise stated or implied from the context, a first component within a semiconductor die (e.g., a transistor or other semiconductor device) is "above" a second component within the semiconductor die when the first component is farther away from a substrate (e.g., a semiconductor wafer) during fabrication/manufacturing than the second component on which the two components are fabricated or otherwise provided. Similarly, unless otherwise stated or implied from the context, a first component within an IC package (e.g., a semiconductor die) is "above" a second component within the IC package during fabrication when the first component is farther away from a printed circuit board (PCB) to which the IC package is to be mounted or attached. It is to be understood that semiconductor devices are often used in orientation different than their orientation during fabrication. Thus, when referring to a semiconductor device (e.g., a transistor), a semiconductor die containing a semiconductor device, and/or an integrated circuit (IC) package containing a semiconductor die during use, the definition of "above" in the preceding paragraph (i.e., the term "above" describes the relationship of two parts relative to Earth) will likely govern based on the usage context.

As used in this patent, stating that any part (e.g., a layer, film, area, region, or plate) is in any way on (e.g., positioned on, located on, disposed on, or formed on, etc.) another part, indicates that the referenced part is either in contact with the other part, or that the referenced part is above the other part with one or more intermediate part(s) located therebetween.

As used herein, connection references (e.g., attached, coupled, connected, and joined) may include intermediate members between the elements referenced by the connection reference and/or relative movement between those elements unless otherwise indicated. As such, connection references do not necessarily infer that two elements are directly connected and/or in fixed relation to each other. As used herein, stating that any part is in "contact" with another part is defined to mean that there is no intermediate part between the two parts.

Unless specifically stated otherwise, descriptors such as "first," "second," "third," etc., are used herein without imputing or otherwise indicating any meaning of priority, physical order, arrangement in a list, and/or ordering in any way, but are merely used as labels and/or arbitrary names to distinguish elements for ease of understanding the disclosed examples. In some examples, the descriptor "first" may be used to refer to an element in the detailed description, while the same element may be referred to in a claim with a different descriptor such as "second" or "third." In such instances, it should be understood that such descriptors are used merely for identifying those elements distinctly within the context of the discussion (e.g., within a claim) in which the elements might, for example, otherwise share a same name.

As used herein, "about" modifies its subjects/values to recognize the potential presence of variations that occur in real world applications. For example, "about" may modify dimensions and/or values that may not be exact due to manufacturing tolerances and/or other real-world imperfections as will be understood by persons of ordinary skill in the art. For example, "about" may indicate such dimensions and/or values may be within a tolerance range of +/- 10% unless otherwise specified herein.

As used herein, the phrase "in communication," including variations thereof, encompasses direct communication and/or indirect communication through one or more intermediary components, and does not require direct physical (e.g., wired) communication and/or constant communication, but rather additionally includes selective communication at periodic intervals, scheduled intervals, aperiodic intervals, and/or one-time events.

As used herein, "programmable circuitry" is defined to include (i) one or more special purpose electrical circuits (e.g., an application specific circuit (ASIC)) structured to perform specific operation(s) and including one or more semiconductor-based logic devices (e.g., electrical hardware implemented by one or more transistors), and/or (ii) one or more general purpose semiconductor-based electrical circuits programmable with instructions to perform specific functions(s) and/or operation(s) and including one or more semiconductor-based logic devices (e.g., electrical hardware implemented by one or more transistors). Examples of programmable circuitry include programmable microprocessors such as Central Processor Units (CPUs) that may execute first instructions to perform one or more operations and/or functions, Field Programmable Gate Arrays (FPGAs) that may be programmed with second instructions to cause configuration and/or structuring of the FPGAs to instantiate one or more operations and/or functions corresponding to the first instructions, Graphics Processor Units (GPUs) that may execute first instructions to perform one or more operations and/or functions, Digital Signal Processors (DSPs) that may execute first instructions to perform one or more operations and/or functions, XPUs, Network Processing Units (NPUs) one or more microcontrollers that may execute first instructions to perform one or more operations and/or functions and/or integrated circuits such as Application Specific Integrated Circuits (ASICs). For example, an XPU may be implemented by a heterogeneous computing system including multiple types of programmable circuitry (e.g., one or more FPGAs, one or more CPUs, one or more GPUs, one or more NPUs, one or more DSPs, etc., and/or any combination(s) thereof), and orchestration technology (e.g., application programming interface(s) (API(s)) that may assign computing task(s) to whichever one(s) of the multiple types of programmable circuitry is/are suited and available to perform the computing task(s).

As used herein integrated circuit/circuitry is defined as one or more semiconductor packages containing one or more circuit elements such as transistors, capacitors, inductors, resistors, current paths, diodes, etc. For example, an integrated circuit may be implemented as one or more of an ASIC, an FPGA, a chip, a microchip, programmable circuitry, a semiconductor substrate coupling multiple circuit elements, a system on chip (SoC), etc.

From the foregoing, it will be appreciated that example systems, apparatus, articles of manufacture, and methods have been disclosed that provide latent fault detection and prevent system failure resulting from latent faults. Example disclosed herein also include predictive latent fault analysis to allow for repair of a potentially defective communication channel before a latent fault manifests. In addition to detecting latent faults, examples disclosed herein also screen for static faults both before and after a part is deployed to the field.

As such, examples disclosed herein improve fault detection in integrated circuits. For example, disclosed systems, apparatus, articles of manufacture, and methods detect latent faults (e.g., 100% of latent faults or transient faults). Additionally, examples disclosed herein include predictive infield repair before a transient fault occurs. Additionally, examples disclosed herein include opportunistic infield testing of communication channels which can provide lifesaving monitoring (e.g., in automotive applications) and confidentiality of privileged assets in data centers (e.g., a banking server). Disclosed systems, apparatus, articles of manufacture, and methods improve the efficiency of using a computing device by detecting and/or predicting latent faults in communication channels and repairing the communication channels. Disclosed systems, apparatus, articles of manufacture, and methods are accordingly directed to one or more improvement(s) in the operation of a machine such as a computer or other electronic and/or mechanical device.

Example methods, apparatus, systems, and articles of manufacture to perform infield testing of a system in a package are disclosed herein. Further examples and combinations thereof include the following:
Example 1 includes a die comprising transmit circuits to communicate via respective communication channels, and control circuitry to cause a first one of the transmit circuits to send a first pattern over a first one of the communication channels, and cause second ones of the transmit circuits to respectively send a second pattern over second respective ones of the communication channels, the second pattern being at least one of an inverse of the first pattern or identical to the first pattern.
Example 2 includes the die of example 1, wherein the control circuitry is to cause the first one of the transmit circuits to send the first pattern at a first time and cause the second ones of the transmit circuits to send the second pattern at the first time, and cause a third one of the transmit circuits to send the first pattern at a second time and cause the first one and the second ones of the transmit circuits to send the second pattern at the second time.
Example 3 includes the die of any of examples 1 or 2, wherein the control circuitry is first control circuitry, the die is a first die, and further including a second die, the second die including a receive circuit to receive the first pattern, the receive circuit to generate an error bit indicative of whether the first pattern matches a control pattern, and second control circuitry to identify the first one of the respective communication channels as defective based on the error bit.
Example 4 includes the die of any of examples 1, 2, or 3, wherein respective ones of the transmit circuits include at least one multiplexer, respective multiplexers of the transmit circuits to shift signals from a defective one of the communication channels to a redundant one of the communication channels.
Example 5 includes the die of any of examples 1, 2, or 4, wherein the control circuitry is first control circuitry, the die is a first die, and further including a second die, the second die including a first receive circuit to receive the first pattern and to generate a first error bit based on a first comparison between the first pattern and a first control pattern, and a second receive circuit to generate a second error bit based on a second comparison between the second pattern and a second control pattern, and second control circuitry to identify one or more of the respective communication channels as defective, based on the first error bit and the second error bit.
Example 6 includes the die of example 5, wherein the first receive circuit and the second receive circuit are to operate at a first frequency, and the second control circuitry is to after initializing the first receive circuit to a first value and the second receive circuit to a second value, disable (1) respective first clocks having the first frequency and (2) respective second clocks having a second frequency, cause the first receive circuit and the second receive circuit to operate at the second frequency, the second frequency greater than the first frequency, and enable the respective second clocks to cause (1) the first receive circuit to receive the first pattern and (2) the second receive circuit to receive the second pattern.
Example 7 includes the die of example 6, wherein the second control circuitry is to after a threshold number of clock cycles of the respective second clocks, disable the respective second clocks, cause the first receive circuit and the second receive circuit to operate at the first frequency, and read a register including the first error bit and the second error bit.
Example 8 includes an apparatus comprising interface circuitry, machine-readable instructions, and at least one processor circuit to be programmed by the machine-readable instructions to program a transmitter with initial values for patterns to be sent by the transmitter over communication channels, and read a register set by a receiver based on patterns received at the receiver, the register to indicate whether one or more of the communication channels is defective.
Example 9 includes the apparatus of example 8, wherein one or more of the at least one processor circuit is to, based on a value of the register indicating that a first one of the communication channels is defective, set a repair register to cause the transmitter and the receiver to utilize a second one of the communication channels instead of the first one of the communication channels.
Example 10 includes the apparatus of any of examples 8 or 9, wherein the initial values are first initial values, and one or more of the at least one processor circuit is to program the receiver with second initial values.
Example 11 includes the apparatus of any of examples 8, 9, or 10, including protocol converter circuitry to convert transactions to program the transmitter and the receiver from a first protocol utilized by the at least one processor circuit to a second protocol utilized by the transmitter and the receiver.
Example 12 includes the apparatus of any of examples 8, 9, 10, or 11, wherein one or more of the at least one processor circuit is to initiate a test based on at least one of a trigger event.
Example 13 includes the apparatus of any of examples 8, 9, 10, 11, or 12, wherein the transmitter is on a first die, and the receiver is on a second die.
Example 14 includes the apparatus of example 13, wherein the first die and the second die are on a substrate integrated in a package.
Example 15 includes a semiconductor package comprising a sensor to monitor a first communication channel between a transmitter and a receiver, machine-readable instructions, and at least one processor circuit to be programmed by the machine-readable instructions to set a threshold margin for the sensor, the threshold margin associated with performance of the first communication channel, and based on an interrupt associated with satisfaction of the threshold margin, set a register to cause the transmitter and the receiver to utilize a second communication channel instead of the first communication channel.
Example 16 includes the semiconductor package of example 15, wherein the threshold margin is based on one or more of (a) process technology used to fabricate at least one of the transmitter, the receiver, or the first communication channel, (b) historical data associated with an application for which the first communication channel is to be utilized, or (c) performance of at least one of the transmitter, the receiver, or the first communication channel.
Example 17 includes the semiconductor package of any of examples 15 or 16, further including a first die including the transmitter, and a second die including the receiver.
Example 18 includes the semiconductor package of any of examples 15, 16, or 17, wherein the sensor is a first sensor, the threshold margin is a first threshold margin, the semiconductor package includes a second sensor to monitor the second communication channel, and one or more of the at least one processor circuit is to set a second threshold margin for the second sensor, the second threshold margin associated with performance of the second communication channel.
Example 19 includes the semiconductor package of any of examples 15, 16, 17, or 18, wherein the transmitter includes a first transmit circuit, the first communication channel is to conduct a first signal, the second communication channel is to conduct a second signal, and the semiconductor package includes decoder circuitry to, based on a value of the register cause a first multiplexer of a second transmit circuit corresponding to the second communication channel to select the first signal instead of the second signal, and cause a second multiplexer associated with a redundant communication channel to select the second signal.
Example 20 includes the semiconductor package of example 19, wherein the receiver includes a first receive circuit, and the decoder circuitry is to, based on the value of the register cause a third multiplexer of the first receive circuit to select the first signal received over the second communication channel, and cause a fourth multiplexer of a second receive circuit to select the second signal received over the redundant communication channel.

The following claims are hereby incorporated into this Detailed Description by this reference. Although certain example systems, apparatus, articles of manufacture, and methods have been disclosed herein, the scope of coverage of this patent is not limited thereto. On the contrary, this patent covers all systems, apparatus, articles of manufacture, and methods fairly falling within the scope of the claims of this patent.

## Claims

1. A die comprising:
transmit circuits to communicate via respective communication channels; and
control circuitry to:
cause a first one of the transmit circuits to send a first pattern over a first one of the communication channels; and
cause second ones of the transmit circuits to respectively send a second pattern over second respective ones of the communication channels, the second pattern being at least one of an inverse of the first pattern or identical to the first pattern.

2. The die of claim 1, wherein the control circuitry is to:
cause the first one of the transmit circuits to send the first pattern at a first time and cause the second ones of the transmit circuits to send the second pattern at the first time; and
cause a third one of the transmit circuits to send the first pattern at a second time and cause the first one and the second ones of the transmit circuits to send the second pattern at the second time.

3. The die of any of claims 1 or 2, wherein the control circuitry is first control circuitry, the die is a first die, and including a second die, the second die including:
a receive circuit to receive the first pattern, the receive circuit to generate an error bit indicative of whether the first pattern matches a control pattern; and
second control circuitry to identify the first one of the respective communication channels as defective based on the error bit.

4. The die of any of claims 1, 2, or 3, wherein respective ones of the transmit circuits include at least one multiplexer, respective multiplexers of the transmit circuits to shift signals from a defective one of the communication channels to a redundant one of the communication channels.

5. The die of any of claims 1, 2, 3, or 4, wherein the control circuitry is first control circuitry, the die is a first die, and including a second die, the second die including:
a first receive circuit to receive the first pattern and to generate a first error bit based on a first comparison between the first pattern and a first control pattern; and
a second receive circuit to generate a second error bit based on a second comparison between the second pattern and a second control pattern; and
second control circuitry to identify one or more of the respective communication channels as defective, based on the first error bit and the second error bit.

6. The die of any of claims 1, 2, 3, 4, or 5, wherein the first receive circuit and the second receive circuit are to operate at a first frequency, and the second control circuitry is to:
after initializing the first receive circuit to a first value and the second receive circuit to a second value, disable (1) respective first clocks having the first frequency and (2) respective second clocks having a second frequency;
cause the first receive circuit and the second receive circuit to operate at the second frequency, the second frequency greater than the first frequency; and
enable the respective second clocks to cause (1) the first receive circuit to receive the first pattern and (2) the second receive circuit to receive the second pattern.

7. The die of any of claims 1, 2, 3, 4, 5, or 6, wherein the second control circuitry is to:
after a threshold number of clock cycles of the respective second clocks, disable the respective second clocks;
cause the first receive circuit and the second receive circuit to operate at the first frequency; and
read a register including the first error bit and the second error bit.

8. A computer-readable medium comprising machine-readable instructions to cause at least one programmable circuit to:
program a transmitter with initial values for patterns to be sent by the transmitter over communication channels; and
read a register set by a receiver based on patterns received at the receiver, the register to indicate whether one or more of the communication channels is defective.

9. The computer-readable medium of claim 8, wherein the machine-readable instructions cause one or more of the at least one programmable circuit to, based on a value of the register indicating that a first one of the communication channels is defective, set a repair register to cause the transmitter and the receiver to utilize a second one of the communication channels instead of the first one of the communication channels.

10. The computer-readable medium of any of claims 8 or 9, wherein the initial values are first initial values, and the machine-readable instructions cause one or more of the at least one programmable circuit is to program the receiver with second initial values.

11. The computer-readable medium of any of claims 8, 9, and 10, wherein the machine-readable instructions cause one or more of the at least one programmable circuit to identify a partition in a package based on a trigger event, the partition including the transmitter and the receiver.

12. The computer-readable medium of any of claims 8, 9, 10, or **11,** wherein the machine-readable instructions cause one or more of the at least one programmable circuit to initiate a test based on at least one of a trigger event.

13. The computer-readable medium of any of claims 8, 9, 10, **11,** or 12, wherein:
the transmitter is on a first die; and
the receiver is on a second die.

14. The computer-readable medium of claim 13, wherein the first die and the second die are on a substrate integrated in a package.

15. A method to implement the machine-readable instructions of any of claims 8-14.
